# EUROPEAN PATENT SPECIFICATION

(11) **EP 4 502 105 B1**
(45) Date of publication and mention of the grant of the patent: **23.07.2025**
(21) Application number: 23189892.5
(22) Date of filing: 04.08.2023
(51) Int. Cl.: C09K 11/06, C07F 3/00, C07F 5/02, C07F 7/10

(54) **DIVALENT EUROPIUM-ORGANIC COORDINATION COMPOUND AND METHOD FOR PRODUCING THE SAME**
ZWEIWERTIGE EUROPIUM-ORGANISCHE KOORDINATIONSVERBINDUNG UND VERFAHREN ZU DEREN HERSTELLUNG
COMPOSÉ DE COORDINATION ORGANIQUE-EUROPIUM DIVALENT ET SON PROCÉDÉ DE PRODUCTION

(43) Date of publication of application: 05.02.2025
(73) Proprietor: beeOLED GmbH, 01217 Dresden (DE)
(72) Inventor: Barthel, André, 01159 Dresden (DE); Tkachov, Roman, 01159 Dresden (DE); Mewes, Jan-Michael, 53129 Bonn (DE)
(74) Representative: Altmann, Andreas

(56) References cited:
- WO-A1-2021/244801
- WO-A1-2022/218562
- CN-A- 115 677 736
- CN-B- 113 801 148

## Description

### Technical Field

The invention concerns a metal-organic coordination compound, wherein the coordination compound comprises a divalent Europium cation coordinated by a macrocyclic organic ligand, and two iodide anions, an organic electronic device containing the same, and methods for forming the same, in particular using thermal evaporation, or sublimation, or casting from solution.

### Background

Many applications relevant to physical and, in particular, to optoelectronic processes make use of lanthanide ions with their chemically well-shielded inner f-f transitions. One of the most important applications are electroluminescent devices based on organic light emitting diodes (OLEDs) for example for consumer displays. Lanthanide ions, especially divalent Europium, Eu (II)), possess significant advantages over conventionally used organic fluorescent emitters in terms of efficiency.

Electroluminescent devices that make use of OLEDs are state-of-the-art for flat panel display applications used in everyday consumer electronics. For OLEDs, special organic materials, so-called emitters, are employed for the purpose of converting electrical excitation into light emission. For consumer display applications, red, green, and blue emitters are needed. However, the development is most exclusively focused on blue emitter materials. The reason is twofold: Firstly, existing red and green emitter materials do combine high efficiency with saturated colors and good chemical stability, whereas only blue emitter materials with poor light-generation efficiency offer reasonable chemical stability. Secondly, advanced consumer display layouts use color conversion to generate the red and green spectral portions from the short wavelength blue emission. Therefore, only blue emitting electroluminescent OLED devices are needed in future displays. Thus, there is an urgent need for a saturated deep blue emitter with high efficiency and good chemical stability.
Here, coordination compounds based on intrametallic transitions of divalent Europium offer very promising properties: The ground state configuration features a half-filled 4d-shell, resulting in a single narrow Gaussian peak in the emission spectrum. At the same time, the emitting state is the lowest excited state of the materials; no undesired longer-lived states are possible. Moreover, as a heavy metal, Europium readily interconverts singlet and triplet excitons that form upon charge-recombination on organic host materials, such that both can be harvested for light generation with Eu-based emitters, leading, in theory, to 100% electroluminescence efficiency. Finally, the transition energy of the first electronically excited divalent Europium coordinated with a wide variety of organic ligands appears in the desired deep blue spectral region between 430 and 500nm. Unlike most trivalent lanthanides, the transition responsible for the emission from divalent Europium is Laporte allowed and thus has a lifetime of only 1.25 µs, which is sufficiently short for consumer display applications.

Further, the transition responsible for light emission from Eu(II) complexes is intrametallic and thus strongly confined on the central Eu cation. Thus, electronically exciting the complex does not weaken any chemical bonds, offering the potential of exceptional chemical stability. Yet, during electroluminescent device operation, charge-trapping on Eu frequently occurs, which corresponds to an oxidation of Eu(II) to Eu(III). Consequently, another mandatory requirement for stable OLED operation is a reversible oxidation/reduction, requiring a stabilization of Eu(II) over Eu(III). This creates a certain challenge, since the most stable oxidation state of Eu is typically the trivalent one. In other words, a stabilization of oxidized trivalent europium after it has captured a positive charge must be avoided, which can be accomplished by using rigid coordination environments and hard anions. Thus, prior the applications of divalent Europium in electroluminescent devices, one needs a reasonably oxidation-stable metal-organic compound. Two major strategies to stabilize divalent Europium are discussed in the literature. First, using soft and polarizable ligands, electronic stabilization is achieved, which, however, stabilizes the excited d-electron so much that the emission is not blue any longer. The second strategy uses size discriminating macrocyclic ligands. Here, stabilization is achieved geometrically by tuning the cavity size to match divalent, but not trivalent Europium.

Sufficient electronic stabilization may be achieved by using soft cyclopentadienyl type ligands as for example disclosed in Kelly, Rory P., et al. Organometallics 34.23 (2015): 5624-5636. Given their symmetrical, low dipole structure, those materials are even sufficiently volatile for sublimation. However, the original deep blue emission of divalent Europium is shifted into the far-red spectral region, not desirable for display applications.

US 6,492,526 discloses a metal-organic complex comprising divalent Europium and charged pyrazolyl borate ligands. In this case, the desired stabilization of the divalent oxidation state is achieved by application of the strong electron-donating chelating ligand. Yet, such a strong electron-donating ligand leads to red shifted emission compared to the desirable deep blue emission from the free Eu(II) cation. Using the same approach green electroluminescent devices were exemplified by Guo, Ruoyao, et al. Molecules 27.22 (2022): 8053.

A specific strategy to prevent oxidation is to incorporate soft coordinating ligands, such as sulphur or aromatic aryl or heteroaryl rings into the coordination sphere of the central metal. Thereby, oxidation stability of the central metal may be observed, see Gamage, Nipuni-Dhanesha H., et al. Angewandte Chemie 122.47 (2010): 9107-9109. However, such soft coordinating atoms in an asymmetrical environment typically cause the originally deep blue and spectrally pure emission to red-shift substantially to the green and red spectral region and to spectrally broaden, which renders those metal-organic coordination compounds undesirable for use in opto-electronic devices.

Another related art to combine the desired properties of divalent Europium with the benefits of organic processing are metal-organic coordination compounds, in which the reactive metal cation is stabilized by cyclic polyether ligands (crown ethers) or bicyclic macrocyclic ligands (cryptands), see the review by Jiang, Jianzhuang, et al. in Coordination Chemistry Reviews 170.1 (1998): 1-29. Besides aliphatic cyclic polyethers, cyclic ligands incorporating heteroaryl rings are also reported in the art. For instance, synthesis and optical properties of bis(perchlorato)(bis-pyridino-18-crown) europium(ll) were disclosed by Christoffers, Starynowicz, Polyhedron 27 (2008): 268. The inclusion of coordinating pyridine rings into the ligand structure led to a significant quenching of the emission, as well as red shifting and broadening the luminescence spectrum.

In most of reported Eu (II) coordination compounds having crown ether ligands, the mandatory charge neutrality is achieved by incorporation of ClO4⁻, Cl⁻ or Br counterions. In contrast there are only few examples reported with Iodide being part of the Eu (II) crown ether-based coordination compound. Among them are Eu(II)I₂ coordinated by 18-crown-6, see Merzlyakova, Silke, et al., J. Am. Chem. Soc. 143 (2021): 798; and benzo-18-crown-6, see Poe, Molinari, et. al. Cryst. Growth Des. 22.1 (2022): 842-852. Smaller crowns, particularly, 12-crown-4 and 15-crown-5, where also used to form coordination compounds with Eu(II)I₂, which however, possess a larger than 1:1 Eu:ligand stoichiometry, see Okaue, Tomita, et al., Nippon Kagaku Kaishi. 5 (1993): 439-444. Among hetero-crown ethers, only nitrogen in the form of a diaza-crown substituted with benzyl groups, i.e., 1,10-dibenzyl-1,10-diaza-18-crown-6, was utilized to make coordination compound with EuI₂, which emits blue light, see Poe, Gaiser et al, Cryst. Growth Des. 22.4 (2022): 2670-2678.

In all those cases, the central metal ion has mainly been coordinated to electron rich hard donor atoms, such as oxygen and nitrogen. Consequently, there is little electronic stabilization achieved here. The coordination compounds, albeit still blue emitting, remain air sensitive.

It is also noteworthy that most of the reported divalent Europium complexes utilize hard counterions, such as, perchlorate, or small-sized halogen anions (Cl⁻, Br) and there are only a few examples in the art of crown-based Eu(II) coordination compounds having soft counterions, in particular iodide. While many of reported materials exhibit blue luminescence, their sublimation ability is generally not given and hence as well not demonstrated thus hindering their efficient application into OLED devices.

Hence, to date, no coordination compounds are known that combine all the desired photophysical properties of divalent Europium with good oxidative stability and sufficient volatility to enable fabrication under ambient (non-oxygen free) conditions and/or via gas transfer processes.

Consequently, the favourable deep blue emission characteristics of divalent Europium have not yet successfully been demonstrated in highly efficient electroluminescent devices. By coordinating divalent europium using rigid symmetrical polymacrocyclic ligands, only yellow-green emission was achieved in Li, J., Wang, L., Zhao, Z. et al. Nat Commun 11, 5218 (2020). A substituted deep blue emitting symmetrical polymacrocyclic aza cryptand is disclosed in WO 2021/244801 A1, yet the disclosed materials typically do not offer sufficient volatility required for display mass production. In the absence of sufficient volatility, electroluminescent devices have been demonstrated using solution processing, but efficiencies were rather poor.

Although OLEDs have been demonstrated with Eu(II) emitters based on cryptand ligands, those particular emitters can hardly be employed for the mass production of consumer displays. Here, the vast majority of all consumer OLED displays are produced using thermal evaporation or sublimation, which was typically not possible using the deep blue emitting materials based on symmetrical ligand design disclosed in WO 2021/244801 A1. In fact, the green-emitting devices disclosed in Li, J., Wang, L., Zhao, Z. et al. Nat Commun 11, 5218 (2020) were processed using thermal sublimation. However, the sublimation yield was only about 10%. Additionally, significant thermal decomposition has been observed during the sublimation process, which renders this material not suitable for mass production using sublimation. In WO 2022/218562, twofold negatively charged polymacrocyclic ligands for Eu(II) are disclosed for improved thermal vacuum sublimation based on the same basic symmetrical cryptand design as Li, J., Wang, L., Zhao, Z. et al. Nat Commun 11, (2020): 5218 and WO 2021/244801 A1. However, again only green emitting Eu(II) compounds are practiced and, once more, the sublimation yield is well below 100%.

In additional prior art, CN113801148A(B) discloses an Eu (II) complex with an tetra-aza-12-crown-4 with 1:2 Eu:ligand stoichiometry. Although this complex exhibits blue luminescence, it is insoluble and does not sublime, which renders it non practical for OLED.

In a related art, CN115677736A discloses a chiral version of tetra-aza-12-crown-4 and 8NH-cryptands-based Eu(II) complexes. Here again, the aza-crown-based complexes have blue emission, however they are insoluble and not volatile, whereas the chiral cryptand-based complexes do not emit blue light and the sublimation yield is well below 100%. In the absence of sufficient volatility, electroluminescent devices have been demonstrated using solution processing, thereby demonstrating very poor device efficiencies only.

Blue emitting Eu(II) complexes with substituted triethylenetetramine ligands were reported by Qi, Zhong et al, J. Mater. Chem. C, 11 (2023): 4136-4142. However, those materials decompose upon attempting to sublime, therefore, only solution processed OLEDs were practiced, which are for the most part irrelevant for OLED display mass production and additionally exhibited poor efficiencies only.

Thus, as of today, no deep blue emitting Eu(II) organic coordination compound that can be processed by thermal evaporation or sublimation with high yield and without significant decomposition, is known.

An object underlying the present invention is to provide an electroluminescent coordination compound, which shows deep blue, highly saturated emission combined with an increased sublimation yield such that large area OLED displays can be processed using well-established low-cost sublimation or evaporation technology.

Furthermore, it is an objective to provide an electroluminescent coordination compound that can be reversibly electronically oxidized and reduced again. In particular, the compound shall be able to trap a hole and subsequently trap an electron with high chemical endurance as those are the primary microscopic steps needed for stable operation of an electroluminescent device.

Furthermore, it is an objective to provide a divalent Europium coordination compound with improved ambient stability.

Following extensive research, we surprisingly that the above objectives are simultaneously fulfilled for complexes of Eu(II) with macrocyclic organic ligands having exactly 16 to 23 macrocyclic ring atoms combined with two simple halogen anions selected from I⁻. Further, a substantial increase in the sublimation yield as well as in the ambient stability is observed within the row of the halogen anions, and the highest ambient stability and the sublimation ability are given for complexes with iodide anions.

The objects are achieved by a metal-organic coordination compound, formed of a divalent Europium cation, a macrocyclic organic ligand, and iodide anions in an amount to make the coordination compound electrically neutral or charge-neutral, with the macrocyclic organic ligand comprising 16 to 23, preferably 18 to 20 ring atoms in a single macrocycle ring accommodating the divalent Europium, with the exception of macrocyclic organic ligands M1 to M5: 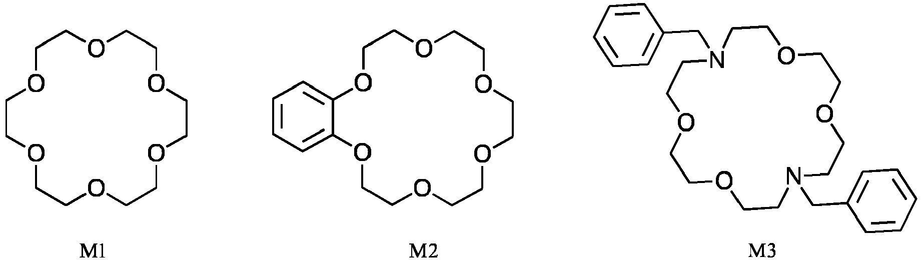 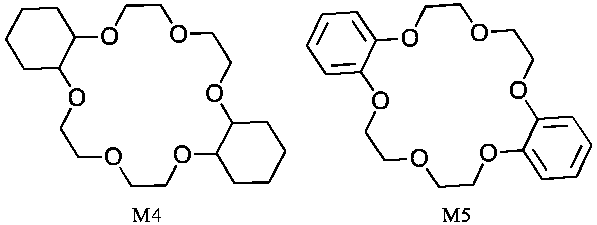 wherein the macrocyclic organic ligand has the formula (1-1): 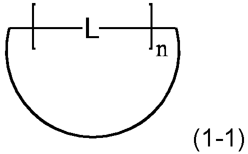 with
- **n** being 4 to 6; more preferable 6 and
- **L** being independently in each occurrence a divalent organic group formed by removing two hydrogen atoms from an organic molecule containing at least two hydrogen atoms, with
   ∘ the shortest sequence of atoms in each **L** between the two linkages of each **L** with the remainder of the macrocycle in the macrocyclic ligand being 2 to 4, preferably 3 or 4 atoms, and with
   ∘ one of those 2 to 4, preferably 3 or 4 atoms independently for each **L** being selected from the heteroatoms B, N, P, S, Se, Si or O, preferably N, S, Se or O, the other atoms in the shortest sequence of atoms being carbon,
wherein preferably the heteroatoms in the macrocycle are non-neighboring.

Preferably, **L** independently in each occurrence is selected from (2-1) to (2-5), wherein
- **R** and **Rₙ** are H, D, or a covalently bound substituent being identical or different in each occurrence, and
- **k** is independently in each occurrence 1 or 2
- two to four instances of **R** present on neighboring carbon atoms independently in each occurrence may fuse, and
- the dashed lines indicate the covalent linkage to the remainder of the macrocyclic ligand according to formula (1-1).

Preferably, any further ring structures, forming part of the macrocyclic organic ligand in addition to the macrocycle itself are covalently linked with one macrocycle atom, or form part of the macrocycle by 1,2-, 1,3- or 1,4-annelation of the further ring structure to the macrocycle, and are not additionally covalently linked with other atoms of the macrocycle.

Preferably, the macrocyclic organic ligand is selected from the generic formulae (3-1) to (3-3), with
- **X** independently in each occurrence being N-**Rₙ**, S, Se, or O, and
- **R** and **Rₙ** being identical or different in each occurrence and being H, D, or any covalently linked monovalent organic group formed by removing a hydrogen atom from an organic molecule containing at least one hydrogen atom, wherein
- two, three, or four instances of **R** being present on the same or neighboring carbon atoms can be fused.

Preferably, the macrocyclic organic ligand is selected from E1 to E12.

Preferably, the metal-organic coordination compound consists of a divalent Europium cation and iodide anions and a macrocyclic organic ligand, with Europium, macrocyclic ligand iodide anions being at 1:1:2 molar ratio.

The object is also achieved by a layer comprising
(a) at least one metal-organic coordination compound, formed of a divalent Europium cation, a macrocyclic organic ligand, and iodide anions in an amount to make the coordination compound electrically neutral, with the macrocyclic organic ligand comprising 16 to 23, preferably 18 to 20 ring atoms, in a single macrocycle ring accommodating the divalent Europium, wherein the macrocyclic organic ligand has the formula (1-1): 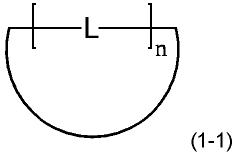 with
   - **n** being 4 to 6; more preferable 6 and
   - **L** being independently in each occurrence a divalent organic group formed by removing two hydrogen atoms from an organic molecule containing at least two hydrogen atoms, with
      ∘ the shortest sequence of atoms in each **L** between the two linkages of each **L** with the remainder of the macrocycle in the macrocyclic ligand being 2 to 4, preferably 3 or 4 atoms, and with
      ∘ one of those 2 to 4, preferably 3 or 4 atoms independently for each **L** being selected from the heteroatoms B, N, P, S, Se, Si or O, preferably N, S, Se or O, the other atoms in the shortest sequence of atoms being carbon,
      wherein preferably the heteroatoms in the macrocycle are non-neighboring,
   and wherein any further ring structures, forming part of the macrocyclic organic ligand in addition to the macrocycle itself are covalently linked with one macrocycle atom, or form part of the macrocycle by 1,2-, 1,3- or 1,4-annelation of the further ring structure to the macrocycle, and are not additionally covalently linked with other atoms of the macrocycle, and
(b) at least one second electrically neutral organic compound different therefrom,
   wherein the at least one metal-organic coordination compound (a) is imbedded into the at least one second electrically neutral organic compound (b),
   the layer preferably having one or more of the following features:
      - the second compound (b) is a charge-neutral host material;
      - the second organic compound (b) has a triplet energy higher than 2.5 eV, preferably higher than 2.6 eV and more preferably higher than 2.7 eV;
      - compounds (a) and (b) are physically mixed or the second charge-neutral compound (b) has a molecular weight Mₙ above 1000 g/mol and the coordination compound (a) and the second charge-neutral compound (b) are chemically linked with each other, for example by a covalent or coordinative chemical bond;
      - the coordination compound (a) is imbedded into the at least one second electrically neutral organic compound (b) in a ratio of 0.1 to 99 vol%, based on the mixture which is 100 vol%;
      - the second organic compound (b) has a lower hole affinity compared to the electrically neutral coordination compound (a);
      - the second organic compound (b) has a lower electron affinity compared to the singly positively charged coordination compound (a);
      - the second material is a charge transport organic material capable of transporting positive or negative charges.

Preferably, the at least one metal-organic coordination compound (a) is selected from metal-organic coordination compounds as defined above.

The object is also achieved by an organic electronic device, comprising:
a first electrode;
a second electrode; and
   an organic layer arranged such that it is electrically interposed between the first and second electrodes, wherein the organic layer comprises at least one metal-organic coordination compound, formed of a divalent Europium cation, a macrocyclic organic ligand, and iodide anions in an amount to make the coordination compound electrically neutral, with the macrocyclic organic ligand comprising 16 to 23, preferably 18 to 20 ring atoms, in a single macrocycle ring accommodating the divalent Europium, wherein the macrocyclic organic ligand has the formula (1-1): 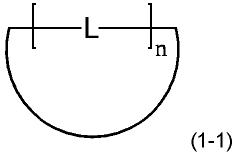 with
      - **n** being 4 to 6; more preferable 6 and
      - **L** being independently in each occurrence a divalent organic group formed by removing two hydrogen atoms from an organic molecule containing at least two hydrogen atoms, with
         ∘ the shortest sequence of atoms in each **L** between the two linkages of each **L** with the remainder of the macrocycle in the macrocyclic ligand being 2 to 4, preferably 3 or 4 atoms, and with
         ∘ one of those 2 to 4, preferably 3 or 4 atoms independently for each **L** being selected from the heteroatoms B, N, P, S, Se, Si or O, preferably N, S, Se or O, the other atoms in the shortest sequence of atoms being carbon,
         wherein preferably the heteroatoms in the macrocycle are non-neighboring,
   and wherein any further ring structures, forming part of the macrocyclic organic ligand in addition to the macrocycle itself are covalently linked with one macrocycle atom, or form part of the macrocycle by 1,2-, 1,3- or 1,4-annelation of the further ring structure to the macrocycle, and are not additionally covalently linked with other atoms of the macrocycle,
or the organic layer is as defined above, wherein preferably the organic electronic device is an optoelectronic device, the optoelectronic device preferably being at least one of an organic light emitting diode, an organic photodetector, or a photovoltaic cell.

The object is also achieved by a method of forming a layer or an organic electronic device, the method comprising:
forming a layer of the metal-organic coordination compound (a), or forming the layer as defined above, wherein the layer is deposited from a gas phase, in particular using an evaporation and/or sublimation and/or carrier gas process, or wherein the layer is deposited from solution, whereby preferably the solution is comprised substantially of organic solvents with a polarity index of less than 5.0, preferably of less than 4.0, more preferably of less than 3.0.
The object is also achieved by the use of the metal-organic coordination compound or of the layer as passive or active light emitting material in electroluminescent electronics applications or as a dye or contrast enhancement medium for magnetic resonance tomography.

In a preferred embodiment, the present invention relates to the use of a symmetrical single macrocyclic crown ether ligand with one Eu(II) placed in the middle, such that two iodide anions can be placed symmetrically atop and below the central Eu(II) cation. Such macrocyclic ligands will still be size discriminating to enable the necessary reduction of trivalent Europium into an excited (divalent) Europium, which must happen during electroluminescent operation. By employing such ligands, it is possible to create symmetric complexes with blue emission and very small dipole moments, resulting in low polarity and sufficient volatility to enable gas transfer processing. Up to now, no such volatile blue emitting complex has been demonstrated.

According to the invention, the divalent Europium is centred inside the macrocyclic ligand. Many anions such as perchlorate, chloride, bromide, cyclopentadienyls, or borates have been investigated in the prior art. Most of them are either chemically very instable, i.e. they cause Eu(II) to easily oxidize, or they lead to a red-shift of the emission of the complex in an OLED. It was found that the ambient and general chemical stability of the complexes comprising iodide anions is significantly improved vs complexes comprising other anions. At the same time, the transition energy, i.e., the emission of the coordination compound is still deep blue as desired for consumer display applications. At the same time, by using macrocyclic organic ligands with 16 to 23 macrocyclic atoms, in combination with iodide anions, coordination compounds of very high volatility, suitable for sublimation or evaporation are obtained. Here, the single macrocyclic coordinating ligand may form an equatorial plane together with the Europium, while the two iodide anions are arranged on an axis perpendicular through this plane, with the Europium in the centre. Thus, the iodide anions are integrated in a way that they simultaneously stabilize the central divalent Europium and, because of symmetry, lead to a small dipole moment for the overall complex, thereby significantly improving its volatility. I addition, only the iodide anion, in the halogenide series, has a sufficiently large size to prevent undesirable penetration of the anions into the inner sphere of the complex (as smaller chlorides and bromides do), which in turn, promotes decomposition of the complexes upon the sublimation. Thus, in a unique combination, highly chemically stable, volatile, and deep blue emitting divalent Europium coordination compounds, perfectly suited for display mass production, are obtained.

OLED design with an emitter according to invention thus becomes very easy because charge transport matrixes with their relatively low LUMO energy's can be successfully employed as well. The combination of the properties mentioned enables the design of very efficient deep blue emitting OLED devices with high operational stability. With this combination of ideal emission characteristics, good processing characteristics, and freedom of OLED design, the coordination compounds according to the invention are ideally suited as active emitting materials in electroluminescent consumer electronics applications.

### Summary of the invention

According to the invention, metal-organic coordination compounds formed of a divalent Europium cation, a macrocyclic organic ligand, and iodide anions in an amount to make the BEE74892EP coordination compound electrically neutral, with the macrocyclic organic ligand comprising 16 to 23, preferably 18 to 20 ring atoms, with the exception of macrocyclic organic ligands M1 to M5: 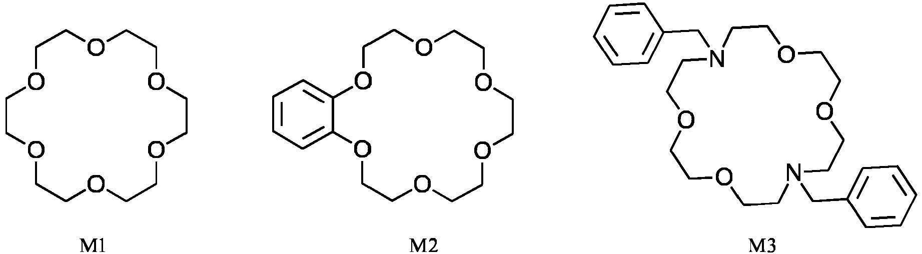 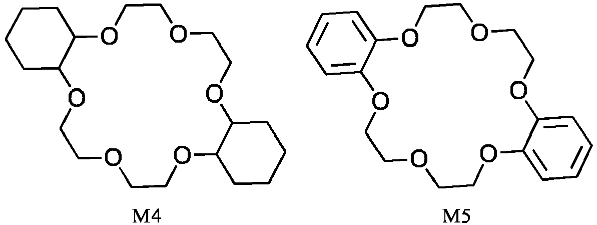 To make use of the potentially excellent emission properties of divalent Europium, the luminescent active cation must be sufficiently chemically stabilized such as to avoid undesired irreversible oxidation of divalent into trivalent Europium. The key ingredient is the use of two iodide anions in combination with macrocyclic organic ligand with a specific cavity formed by 16 to 23 macrocyclic atoms. In this situation, we surprisingly found that iodide anions offer a much superior stabilization of the divalent Europium against oxidation than any other organic or inorganic anion or anionic group, such as other than iodide halogens, alcoholates, or other weakly coordinating anions like BF₄⁻, PF₆⁻, or BArF (fluorinated tetraphenylborate). At the same time, iodide anions arrange on opposing sides of the plane defined by the central cation and the macrocyclic organic ligand, resulting in a low overall dipole moment. Consequently, very high volatility is achieved such that sublimation yields close to 100% are typically observed. Finally, the direct metal-anion ionic bond is still sufficiently weak, such that Eu(II) retains its saturated deep blue emission spectrum.

To ensure the preferred symmetrical coordination compounds with low dipole moment, the central divalent Europium must well geometrically fit into the macrocyclic organic ligand that coordinates to it. Thus, the ionic diameter of the divalent Europium must fit the cavity formed by the macrocyclic ligand. The latter may depend somewhat on what atoms (carbon atoms and heteroatoms) exactly are present as part of the macrocycle forming "the care" of the macrocyclic organic ligand. For example, replacing oxygen by sulfur in a heterocyclic structure slightly increases the ring size due to the longer carbon-sulfur bond. However, a good coordination of the divalent Europium ion by the macrocyclic organic ligand is generally achieved if the shortest sequence of atoms forming the macrocycle in the macrocyclic organic ligand being made of 16 to 23 preferably 18 to 20 covalently linked atoms, wherein preferably the macrocycle contains 4 to 6 non neighboring heteroatoms, preferably the metal organic coordination compound is charge neutral and contains two iodide anions.

The macrocyclic ligand itself may preferably be chosen according to the generic formula (1-1): 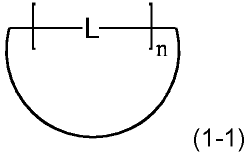 with n being 4 to 6, more preferable 6 and L being independently in each occurrence a divalent organic group formed by removing two hydrogen atoms from an organic molecule containing at least two hydrogen atoms, with the shortest sequence of atoms linking each **L** with the remainder of the macrocycle in the macrocyclic ligand being 2 to 4 atoms, preferably 3 or 4 atoms, and with one of those 2 to 4 atoms preferably 3 or 4 atoms independently for each **L** being selected from the heteroatoms B, N, P, S, Se, Si or O, preferably N, S, or O, the other atoms of those atoms being carbon, wherein preferably the heteroatoms in the macrocycle are non-neighboring.

Here, the macrocyclic organic ligand is constituted of n subunits, each containing at least one heteroatom. The heteroatoms ensure good coordination of Eu(II) by the macrocyclic organic ligand and are preferably selected from N, P, O, S, and Se. Yet, Group 6 and hard Group 5 donor atoms cause less undesirable red-shift of the emission energy, so preference is given to the heteroatoms N, S, and O. In addition to the coordinating heteroatom(s), 2 to 4 carbon atoms are present in the shortest sequence of atoms linking each subunit **L** to the remainder of the macrocycle, which helps to form chemically stable configurations with the total number of atoms in the macrocycle to be from 16 to 23, preferably 18 to 20. Preference is given to structures where the heteroatoms are non-adjacent, more preferably where they are separated from each other by two or four, more preferably by three carbon atoms, i.e., for subunits each containing two carbon atoms and one heteroatom. Further, the number of coordination heteroatoms as part of the macrocycle in the organic macrocyclic ligand is 4 to 6, more preferably 6. Together with the preferred two additional carbon atoms for every heteroatom and arranged symmetrically around each heteroatom, one arrives at the chemically very robust and widely known 18-crown-6 motive, where 18 describes the number of macrocyclic atoms in the cyclic ligand and 6 denotes the number of heteroatoms thereof, known as hetero-crown ethers. Such macrocyclic organic ligands perfectly stabilize the central divalent Europium over trivalent Europium if combined with the iodide anions.

Preferably, the subunits L are even more specifically independently in each occurrence selected from formula (2-1) to (2-5): 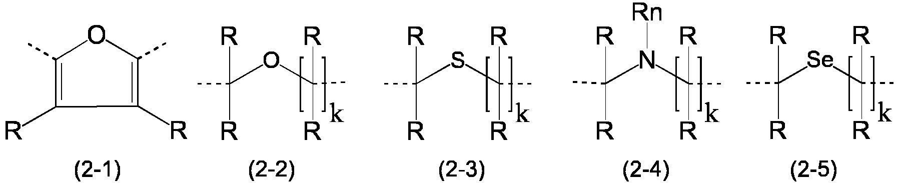 with **R** and **Rₙ** being H, D, or any covalently linked substituent being identical or different in each occurrence, and the dashed lines indicating the covalent linkage to the remainder of the macrocyclic ligand according to formula (1-1) and **k** being independently in each occurrence equal to 1, or 2 two to four instances of **R** present on neighboring carbon atoms independently in each occurrence may fuse, and the dashed lines indicating the covalent linkage to the remainder of the macrocyclic ligand according to formula (1-1).

In further preferred embodiments, the macrocyclic organic ligand comprises any further ring structures, forming part of the macrocyclic organic ligand in addition to the macrocycle and which are covalently linked with one macrocycle atom, or form part of the macrocycle by 1,2-, 1,3- or 1,4-annelation of the further ring structure, with the remainder of the macrocycle, and which are not additionally covalently linked with other atoms of the macrocycle.

The preferred macrocycle in the macrocyclic ring with its 18 to 20 macrocyclic atoms is constituted of subunits that are chemically robust, well-coordinating, and each individually having a high triplet energy. Again, this selection shall ensure that the energy as well as the electron in the excited state of Eu(II) in the 4d orbital is mostly confined on the central metal, thereby avoiding undesired charge transfer states or Dexter energy transfer. The most desirable properties for OLED operation, i.e., deep blue color and high electron binding energy in the ground and excited state are achieved by the furanyl fragment (2-1) and the purely aliphatic segments (2-2) to (2-5).

Further preferred are rotation- or mirror symmetric organic ligands such as derived from the generic formulae (3-1) to (3-3): 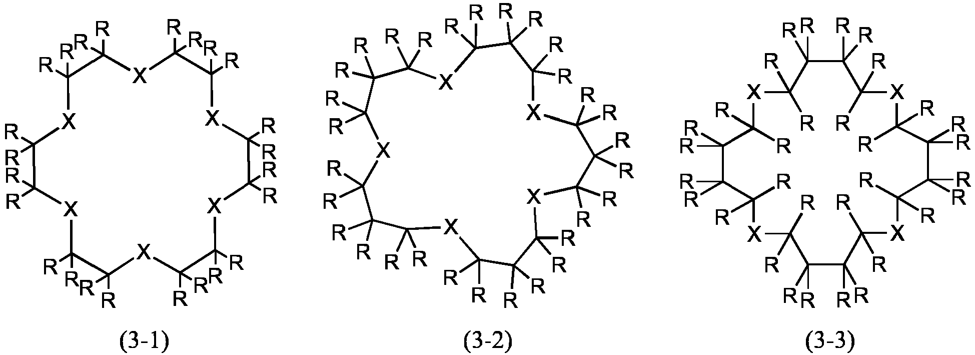 with **X** independently in each occurrence being N-**Rₙ**, S, Se, or O, and **R** and **Rₙ** being identical or different in each occurrence and being H, D, or any covalently linked monovalent organic group formed by removing a hydrogen atom from an organic molecule containing at least one hydrogen atom whereby two, three, or four instances of R being present on the same or neighboring carbon atoms can be fused.

This molecular design ensures favourable size of the macrocycle in the macrocyclic ring with 18, and 20 macrocyclic atoms. With respect to formula (1-1), (3-1), (3-2), and (3-3) are embodiments of n=6, 5, and 4 combined with k as part of (2-2) to (2-5). The substituents R might be any charge neutral, organyl group that is formed by removing one hydrogen from a chemically stable organic molecule. However, substituents R, present on neighbouring carbon atoms in (3-1) to (3-3), may fuse to form aromatic or aliphatic cyclic groups. For example, 4 substituents R present on two neighbouring carbon atoms separated by an oxygen may fuse into a furanyl fragment, i.e., into formula (2-1) from above. The two R on each carbon atom together with the respective (macrocycle) ring carbon atom form a carbon-carbon double bond as in 1,3-butadien. Similarly, 4 R groups present on two neighbouring macrocyclic carbon atoms may form together with them 1,2-phenylene group. See also E5, E7 and E11 below. By adding further fused rings in the 3,4- or 4,5-position, a naphtylene or phenanthrene group can be formed.

In further preferred embodiments, the metal organic coordination compound according to the invention comprises a macrocyclic organic ligand selected from E1 to E12:

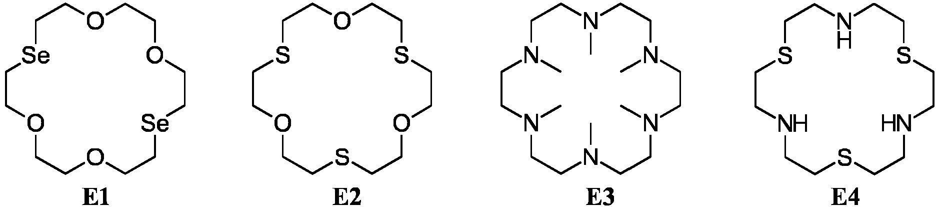

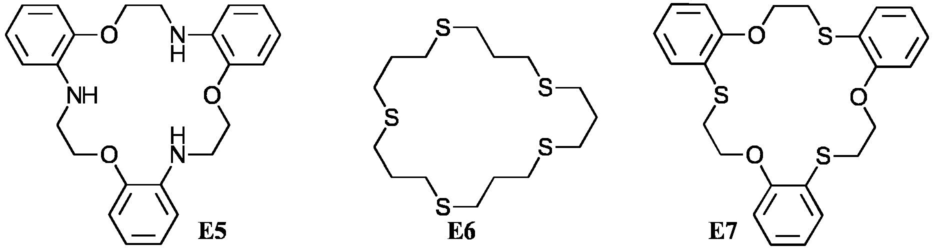

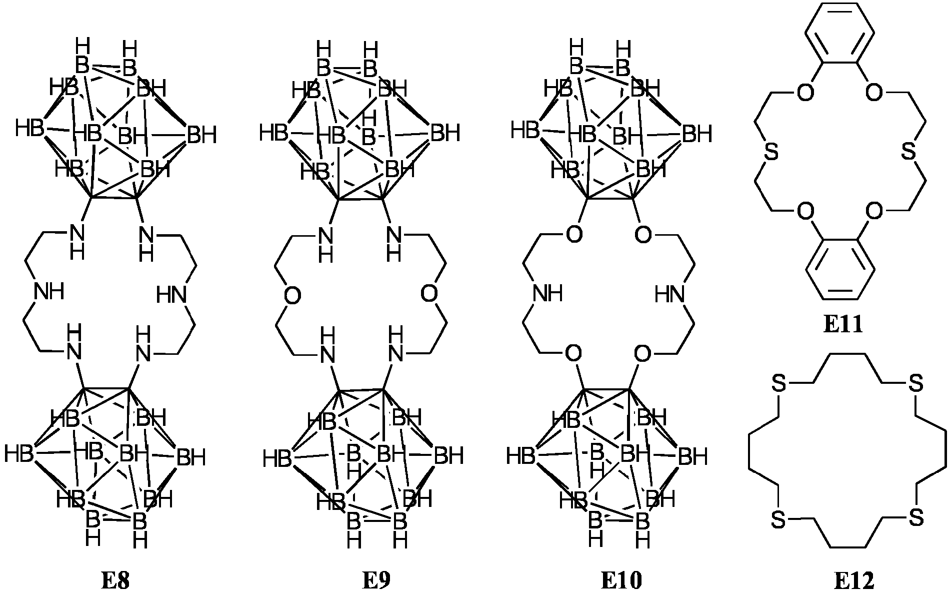

All those embodiments combine a perfect ring size to accommodate divalent Europium to achieve sufficient geometric stabilization with the right amount of electron stabilization provided by the various hetero atoms. The term "macrocyclic" defines that in the coordination compound there is one ring accommodating the divalent Europium (in contrast to polycyclic rings forming a cage for the Europium). The possible presence of e.g. annelated rings as shown in E5 and E7 to E11 is included in this definition, since there is only one ring structure having a length of 16 to 23 atoms forming the ring. Besides E6 and E12, all macrocycles comprise 18 atoms as part of the macrocyclic ligand. E6 consists of 20 atoms whereas E12, of 16 atoms, as part of the macrocyclic ring. With the exception of E6 and E12 having 5 and 4 heteroatoms, respectively, always 6 heteroatoms coordinate to the central metal cation. The heteroatoms are selected from O, N, and S here, and their relative abundance as part of the macrocycle of the macrocyclic ring is fine-tuned to arrive at perfect deep blue colour point and electron-binding energies suitable for OLED devices. The embodiments E1, E2, E4, E6 and E12 are based on non-substituted macrocyclic organic ligands. E3 is based on a macrocyclic organic ligand in which every N coordinating atom contains methyl substituent. In E3, E5, and E11, neighbouring carbon atoms are substituted and fused into benzene rings, whereas in E8 to E10, neighbouring macrocyclic carbon atoms are substituted and fused with an ortho-carborane (C2B10H12), which is linked to the macrocyclic organic ligands via its two carbon atoms. The carborane-containing E8 - E10 differ by the nature and number of coordinating heteroatoms of the macrocyclic organic ligand, and E8 contains six NH groups, E9 - four NH and two oxygen atoms, whereas E10 - two NH groups and four oxygen atoms.

In various preferred embodiments, the metal-organic coordination compound consists of a divalent Europium cation and iodide anions and a macrocyclic organic ligand, with Europium, macrocyclic ligand iodide anions being at 1:1:2 molar ratio.

In various preferred embodiments, the metal-organic coordination compound (a) according to the invention is used in a layer together with at least one second electrically neutral organic compound (b). The second electrically neutral organic compound (b) may preferably be a charge-neutral host material and have a triplet energy higher than 2.5 eV, preferably higher than 2.6 eV and more preferably higher than 2.7 eV. The metal-organic coordination compound (a) may be imbedded into the second electrically neutral organic compound (b), in different ways. Particularly, they may be physically mixed together or chemically linked with each other, for example by a covalent or coordinative chemical bond. The coordination compound may be imbedded into the at least one second electrically neutral organic compound in a ratio of 0.1 to 99 vol%, based on the mixture which is 100 vol%. The second organic compound (b) may have a lower hole affinity compared to the electrically neutral coordination compound and may have a lower electron affinity compared to the singly positively charged coordination compound (a). The second material may be a charge transport organic material capable of transporting positive or negative charges.

In various preferred embodiments, the metal-organic coordination compound according to the invention is used in an organic electronic device, comprising a first electrode, a second electrode, and an organic layer arranged such that it is electrically interposed between the first and second electrodes. Further preferred are embodiments with the organic electronic device being an organic light emitting diode, an organic photodetector, or a photovoltaic cell.

In preferred embodiments, the layer comprising the metal-organic coordination compound according to any of the embodiments described above is deposited from gas phase, in particular, using evaporation and/or sublimation and/or carrier gas processes. Thermal sublimation and/or evaporation are the standard processes used in industrial consumer display production processes and given the high sublimation yield of the materials according to the invention, fabricating organic electronic devices, in particular OLED consumer displays, is readily possible using those processes. Alternatively, the coordination compound applied in the organic electronic device is deposited from solution.

In further preferred embodiments, the coordination compound according to any of the embodiments described above is used as passive or active emitting material in electroluminescent electronics applications or as a dye or contrast enhancement medium for magnetic resonance tomography.

### Brief Description of the Drawings

In the drawings, like reference characters generally refer to the same parts throughout the different views. The drawings are not necessarily to scale, emphasis is instead generally being placed upon illustrating the principles of the invention. In the following description, various aspects of the invention are described with reference to the following drawings, in which:
**FIG. 1** exemplifies various organic side groups and substituents relevant to the invention.
**FIG. 2** exemplifies macrocyclic organic ligands according to the invention.
**FIG. 3** and **FIG. 4****,** illustrate schematic cross sections of organic electronic devices according to various aspects.
**FIG. 5** and **FIG. 6** depict emission spectra of various coordination compounds.
**FIG. 7** shows electroluminescence spectrum of the device.

### Detailed Description

The following detailed description refers to the accompanying drawings that show, by way of illustration, specific details and aspects in which the invention may be practiced.

The word "exemplary" is used herein to mean "serving as an example, instance, or illustration". Any aspect or design described herein as "exemplary" is not necessarily to be construed as preferred or advantageous over other aspects or designs.

Various embodiments relate to metal-organic compounds, including a divalent Europium cation coordinated by a macrocyclic organic ligand and the applications of those compounds.

In this description, a coordination compound is taken to mean a compound where the central active metal, divalent Europium, is coordinated without a direct metal carbon bond. The terms complex, metal-organic compound, and coordination compound will be used interchangeably.

The term "macrocyclic" ring, molecule, or ligand refers to organic molecules comprising at least 9 atoms independently in each occurrence selected from O, S, Si, C, B, N, P as part of cyclic chain of atoms with at least two of the bonds between the ring forming atoms being aliphatic. A crown ether, comprising of at least 3 -C-C-O- fragments is an example of a macrocyclic molecule.

The "aza" designation in the fragments described herein, i.e., aza-crown ether, etc. means that one or more carbon atom or (other) heteroatom of a parent compound is replaced by a nitrogen atom, without any limitation. For example, in a crown ether, -O- is replaced by -NH- to give the respective aza-crown ether. One of ordinary skill in the art can readily envision other nitrogen analogs of the aza-derivatives, and all such analogs are intended to be encompassed by the terms as set forth herein.

As used herein, "deuterium" refers to an isotope of hydrogen. Deuterated compounds can be readily prepared using methods known in the art.

It is to be understood that when a molecular fragment is described as being a substituent or otherwise attached to another moiety, its name may be written as if it were a fragment (e.g., phenyl, phenylene, naphthyl, dibenzofuryl) or as if it were the whole molecule (e.g., benzene, naphthalene, dibenzofuran). As used herein, these different ways of designating a substituent or attached fragment are considered to be equivalent.

The terms "halo," "halogen," and "halide" are used interchangeably and refer to fluorine, chlorine, bromine, and iodine.

In this description, the arylene is a divalent organic fragment that is derived from an aromatic or heteroaromatic hydrocarbon (arene or heteroarene) by removing two hydrogen atoms from the aromatic or heteroaromatic hydrocarbon, preferably from different carbon and/or hetero atoms. One example is a (hetero) aromatic hydrocarbon that has had hydrogen atoms removed from two, preferably adjacent, hydrogen-bearing atoms (in case of aromatic hydrocarbon two carbon atoms, in case of heteroaromatic hydrocarbons two atoms selected from carbon and heteroatoms). An aromatic hydrocarbon or arene (or sometimes aryl hydrocarbon) is a cyclic hydrocarbon comprising only sp²-hybridized carbon atoms, leading to a delocalized π-system. Such (hetero) aromatic units may as well improve the charge transport or charge capture properties of the metal organic coordination compounds. Yet, preference is given to (hetero) aromatic groups with sufficiently high triplet energy to confine the excitation to the central Europium atom and, again, preference is given to relatively strong electron-donating aromatic groups without heteroatoms or with only oxygen or nitrogen as heteroatoms. Each (hetero) aromatic group(s) preferably contain(s) 1 to 5, more preferably 1 to 4, most preferably 1, 2 or 3, preferably fused or annelated, ring structures, preferably (hetero) aromatic) ring structures that contain 0 or 1 non (hetero)aromatic ring, like in a benzofuran group.

An alkylene is a divalent organic fragment that is derived from an alkyl group by removing one additional substituent.

The term "alkyl" refers to and includes both straight and branched alkyl chain radicals and can furthermore also include cycloalkyl radicals. Preferred alkyl groups are those containing from one to fifteen, preferably one to ten, more preferably one to five carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group is optionally substituted, e.g., by halogen, preferably fluorine, or cycloalkyls.

The term "cycloalkyl radical" refers to and includes monocyclic, polycyclic, and spiro alkyl radicals. Preferred cycloalkyl groups are those containing 3 to 12, preferably 3 to 8 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group is optionally substituted, e.g., by halogen, deuterium, alkyl or heteroalkyl.

The terms "heteroalkyl" or "heterocycloalkyl" refer to an alkyl or a cycloalkyl radical, respectively, having at least one carbon atom replaced by a heteroatom. Preferably the at least one heteroatom is selected from O, S, N, P, B, and Si, more preferably O, or N. Preferably 1 to 5, more preferably 1 to 3, most preferably 1 or 2 heteroatoms are present in the radical. The radical can be covalently linked with the remainder of the molecule via a carbon or heteroatom (e.g., N). Additionally, the heteroalkyl or heterocycloalkyl group is optionally substituted as indicated for alkyl and cycloalkyl.

The term "alkenyl" refers to and includes both straight and branched chain alkene radicals. Alkenyl groups are essentially alkyl groups with more than one carbon atom that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl radical having at least one, preferably 1 to 5, more preferably 1 to 3, most preferably 1 or 2 carbon atoms replaced by a heteroatom. Preferably, the at least one heteroatom is selected from O, S, N, P, B, and Si, more preferably O, S, or N. Preferred alkenyl/cycloalkenyl/heteroalkenyl groups are those containing two/three/one to fifteen carbon atoms. Additionally, the alkenyl, cycloalkenyl, or heteroalkenyl group is optionally substituted, as indicated above.

The terms "aralkyl" or "arylalkyl" are used interchangeably and refer to an alkyl group that is substituted with an aryl group. Additionally, the aralkyl group is optionally substituted, as indicated for alkyl and aryl.

The term "heterocyclic group" refers to and includes aromatic and non-aromatic cyclic radicals containing at least one, preferably 1 to 5, more preferably 1 to 3 heteroatoms. Preferably the at least one heteroatom is selected from O, S, N, P, B, and Si, more preferably O, S, or N. Hetero-aromatic cyclic radicals may be used interchangeably with heteroaryl. Preferred hetero-non-aromatic cyclic groups are those containing 3 to 7 ring atoms which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group may be optionally substituted, e.g., by halogen, deuterium, alkyl or aryl. The heterocyclic group can be covalently linked with the remainder of the molecule via carbon and/or heteroatoms, preferably one carbon or nitrogen atom. The heterocyclic group can as well be linked with two carbon and/or heteroatoms with the remainder of the molecule.

The term "aryl" refers to and includes both single-ring aromatic hydrocarbon groups and polycyclic aromatic ring systems. The polycyclic rings may have two or more rings in which two carbons are common to two adjoining rings (the rings are "fused") or wherein one carbon is common to two adjoining rings (e.g., biphenyl) wherein at least one of the rings is an aromatic hydrocarbon group, e.g., the other rings can be cycloalkyls, cycloalkenyls, aryl, heterocycles, and/or heteroaryls. Preferred aryl groups are those containing three to eight aromatic carbon atoms. Especially preferred is an aryl group having six carbons. Suitable aryl groups include phenyl, and radialene. Most preferred is phenyl that can be substituted by non-aromatic groups. Additionally, the aryl group is optionally substituted, e.g., by halogen, alkyl, heteroalkyl, or deuterium. The aryl group is connected to the remainder of the ligand via one or two carbon atoms.

The term "heteroaryl" refers to and includes both single-ring aromatic groups and polycyclic aromatic ring systems that include at least one heteroatom. The heteroatoms include but are not limited to and are preferably selected from O, S, N, P, B, and Si. In many instances, O, S, or N are the preferred heteroatoms. Hetero-single ring aromatic systems are preferably single rings with 5 or 6 ring atoms, and the ring can have from one to five/six, preferably 1 to 3 heteroatoms. The hetero-polycyclic ring systems can have two or more rings in which two atoms are common to two adjoining rings (the rings are "fused") or wherein one carbon is common to two adjoining rings (e.g., bipyridine) wherein at least one of the rings is a heteroaryl, e.g., the other rings can be cycloalkyls, cycloalkenyls. The hetero-polycyclic aromatic ring systems can have from 1 to 5, preferably 1 to 3 heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyrrole, pyrazole, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably 1,3,4-oxadiazole, furan, thiophene, 1,2,4-triazole, 1,2,3-triazole, and pyrazole groups, from which one hydrogen atom has been removed from a hydrogen-bearing carbon or heteroatom to form the covalent link to the remainder of the molecule. The heteroaryl group with two hydrogens removed can as well be linked with two carbon and/or heteroatoms with the remainder of the molecules, in which case the heteroaryl group can be part of a larger cyclic group. Additionally, the heteroaryl group is optionally substituted, e.g., by halogen, deuterium, alkyl or aryl.

Generally, aryl and heteroaryl groups with triplet level > 2.5 eV or more preferably >2.6 eV or most preferably > 2.7 eV such as the groups derived from benzene, furan, dibenzofuran, dibenzoselenophene, carbazole, imidazole, pyridine, pyrazine, pyrimidine, triazine, and the respective aza-analogs of each thereof are of particular interest. There are many possible ways to probe the triplet energy level of an organic molecule. A simple way is to use suitable quantum mechanical calculations. A more experimental way takes the onset of the phosphorescence spectrum, which is usually detected using gated spectroscopy, as pioneered by Romanovskii et al. "Phosphorescence of π-conjugated oligomers and polymers." Physical Review Letters 84.5 (2000): 1027. In combination with high triplet energy, generally preference is given to benzene or low polarizable, hard heteroaryl groups, such as 1,3,4-Oxadiazole, furan, thiophene, 1,2,4-triazole, 1,2,3-triazole, and pyrazole carbazole, dibenzofuran, and benzofuran groups.

The alkyl, cycloalkyl, heteroalkyl, heterocycloalkyl, alkenyl, cycloalkenyl, heteroalkenyl, alkynyl, aralkyl, heterocyclic group, aryl, and heteroaryl groups or residues, as used herein, are independently unsubstituted, or independently substituted, with one or more (general) substituents, preferably the substituents mentioned above.

Preferably, the (general) substituents are selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof with the number of carbon atoms and heteroatoms as defined above for the respective term. Furthermore, one or two substituents can be selected from polymer chains which can be covalently linked with the remainder of the molecule by a suitable organic spacer. Therefore, the cyclic organic ligand can be covalently linked with a polymer chain or a polymer backbone.

In some instances, the preferred general substituents are selected from the group consisting of deuterium, alkyl, cycloalkyl, heteroalkyl, alkoxy, aryloxy, amino, silyl, alkenyl, cycloalkenyl, heteroalkenyl, aryl, heteroaryl, nitrile, isonitrile, sulfanyl, and combinations thereof with the number of carbon atoms and heteroatoms as defined above for the respective term.

In yet other instances, the more preferred general substituents are selected from the group consisting of deuterium, alkyl, cycloalkyl, aryl, heteroaryl, and combinations thereof with the number of carbon atoms and heteroatoms as defined above for the respective term.

The terms "substituted" and "substitution" refer to a substituent other than H that is bonded to the relevant position, e.g., a carbon or nitrogen. For example, when R represents mono-substitution, then one R must be other than H (i.e., a substitution). Similarly, when R represents di-substitution, then two of R must be other than H. Similarly, when R represents no substitution, R, for example, can be a hydrogen for available valencies of straight or branched chain or ring atoms, as in carbon atoms for benzene and the nitrogen atom in pyrrole, or simply represents nothing for ring atoms with fully filled valencies, e.g., the nitrogen atom in pyridine. The maximum number of substitutions possible in a straight or branched chain or ring structure will depend on the total number of available valencies in the ring atoms or number of hydrogen atoms that can be replaced. All residues and substituents are selected in a way that a chemically stable and accessible chemical group results.

Any type of substituent can replace a hydrogen atom in an organic or heterorganic group of compound (a) or (b) or the second organic layer above, as long as it results in a chemical compound which is stable under conditions that occur in an OLED display device or organic electronic device and which does not chemically react with other compounds and components of the OLED display device or organic electronic device.

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include thirty to forty atoms that are not hydrogen or deuterium, or those that include up to 30 atoms that are not hydrogen or deuterium counted for all substituents of a given molecule, or for the respective molecule in total. In various embodiments, a combination of substituent groups will include up to twenty atoms that are not hydrogen or deuterium, counted for all substituents of a given molecule.

In some instances, a pair of adjacent residues can be optionally joined (i.e., covalently linked with each other) or fused into a ring. The preferred ring formed therewith is a five-, six-, or seven-membered carbocyclic or heterocyclic ring, including both instances where the portion of the ring formed by the pair of substituents is saturated and where the portion of the ring formed by the pair of substituents is unsaturated. As used herein, "adjacent" means that the two substituents involved can be on the same ring next to each other, or on two neighboring rings having the two closest available substitutable positions, such as 2, 2' positions in a biphenyl, or 1, 8 position in a naphthalene, or 2,3-positions in a phenyl, or 1,2-positions in a piperidine, as long as they can form a stable fused ring system. In some instances, a pair of non-adjacent substituents can be optionally joined usually by an, at least partial, alkane or heteroalkene chain of atoms, thereby forming another macrocyclic ring system as part of the macrocyclic ring present as part of the coordination compound. In some instances, a pair of substituents present on the same carbon atom can be optionally joined, i.e., into an aryl or heteroaryl group, thus, forming a spiro linkage on said particular carbon atom.

In this description, the term organyl refers to any chemically stable organic arrangement of atoms where one or more hydrogen atom has been removed such as to use those free vacancies to covalently link the organic group with another molecular entity. Thus, the term organyl encompasses the majority of the above defined organic groups e.g., fluorine, alkyl, cycloalkyl, heteroalkyl, alkoxy, aryloxy, amino, silyl, alkenyl, cycloalkenyl, heteroalkenyl, aryl, heteroaryl, nitrile, isonitrile, sulfanyl, and combinations thereof with the number of carbon atoms and heteroatoms as defined above for the respective term. The term organyl shall especially as well encompass sufficiently chemically stable negatively charged species, such as anions, or anionic side groups.

Organic groups are derived or formed by removing one or more hydrogen atoms from organic molecules containing at least a corresponding number of hydrogen atoms. For example, benzene results in phenyl or phenylene groups by removing one or two hydrogen atoms, resulting in a monovalent or divalent organic group.

Suitable organic molecules and groups are as identified above, e.g. alkyl, aryl, heteroaryl groups.

In this description, an electroluminescent coordination compound is any material that is able to emit light upon electrical excitation, resulting from recombination of electrons and holes. It shall be irrelevant in this context whether the recombination of the electrons and holes takes place directly on the electroluminescent compound or first an excitation is formed on a different compound and subsequently transferred to the electroluminescent compound. Further, it shall be irrelevant in this context whether the light emitted is visible for the human eye or not. Especially, compounds emitting infrared and near ultra-violet emission shall be explicitly included. Further, the mixture comprising the electroluminescent coordination compound does not necessarily have to be used in an electronic device but, for example, may be used as a dye or a contrast enhancement medium for magnetic resonance tomography. In particular, it may be used for down-converting high energy photons after optical excitation.

In the OLED community, the emission is usually classified as fluorescence if it originates from an optically allowed (spin-conserving) transition and decays within a few nanoseconds, such as the transition from the first excited singlet state to the singlet ground state, or, as phosphorescence if the emission originates from a spin-forbidden transition and decays with a few micro-milliseconds, such as from the first excited triplet state to the singlet ground state. The emission from the first electronically excited divalent Europium results from an optically allowed spin-conserving d-f transition, which, due to small overlap between the 5d and 4f orbitals, has a rather long excited state lifetime of 1.2 µs (compared to typical fluorescence). Thus, it clearly is neither fluorescent, nor phosphorescent in the typical context used in OLED community. It should correctly be referred to as emission from an intrametallic transition.

All embodiments of the invention contain a metal-organic coordination compound, wherein the coordination compound comprises a divalent Europium and a macrocyclic organic ligand and two iodide anions in a molar ratio of 1:1:2 in the coordination compound. In all metal-organic coordination compounds according to the invention, there is one macrocyclic organic ligand present that coordinates one divalent Europium cation. Outside the present invention are coordination compounds, where one divalent Europium cation is coordinated by two or more macrocyclic organic ligands. The macrocyclic organic ligand excluding the metal is charge neutral and the two positive charges of the Europium cation are charge compensated in the final coordination compound by two iodide anions.

To qualify as a macrocyclic organic ligand according to the invention and the generally accepted definition, at least 16 macrocyclic atoms are part of a single cyclic ring, the macrocycle. Clearly, the overall number of atoms being part of the macrocyclic organic ligand will be higher; note that only those carbon or heteroatoms are counted as macrocyclic atoms that do form the cyclic closed ring system around the Eu(II), i.e., the "macrocycle" according to the invention. For example, the classical dibenzo-18-crown-6 contains 18 macrocyclic atoms (12 carbon and 6 oxygen atoms, respectively, in the macrocycle), while overall 50 atoms are present. Described herein are divalent Europium coordination compounds comprising organic macrocyclic ligands with preferably 16 or a higher number of macrocyclic atoms as part of the cyclic ring, the macrocycle. Yet, for good coordination of the divalent Europium, the cavity formed by the macrocyclic ring should neither be too small nor too large. This cavity, however, depends somewhat on the exact nature of the heteroatoms present in the macrocycle. For example, if nitrogen is substituted by sulfur in a particular aza-crown ether, the number of macrocyclic atoms does obviously not change, yet the cavity size will tendentially increase. Therefore, it is not possible to give an exact number of macrocyclic atoms that would always perform best. However, general preference is given to macrocycles comprising 16 to 23, and most preferably 18 to 20 macrocyclic atoms, i.e., in the macrocycle.

The macrocyclic organic ligand may comprise any element with at least two valencies that is able to form chemically stable cyclic rings. Indeed, an overwhelmingly large number of macrocyclic rings is described in the literature, for example, crown ethers, calixarenes, porphyrins, and cyclodextrins. According to one embodiment the macrocycle may only comprises of non-coordinating atoms, such as Si, or C. However, preference is given to macrocycles with a plurality of heteroatoms being present that are able to coordinate divalent Europium. In such a situation, two macrocyclic heteroatoms might be direct neighbors within the macrocyclic organic ligand and this might give very chemically robust macrocycles. However, preference is given to macrocycles with the coordinating heteroatoms being separated by at least one carbon atom, and more preference is given to arrangements, where each two macrocyclic coordinating heteroatoms are separated from each other by two or three carbon atoms.

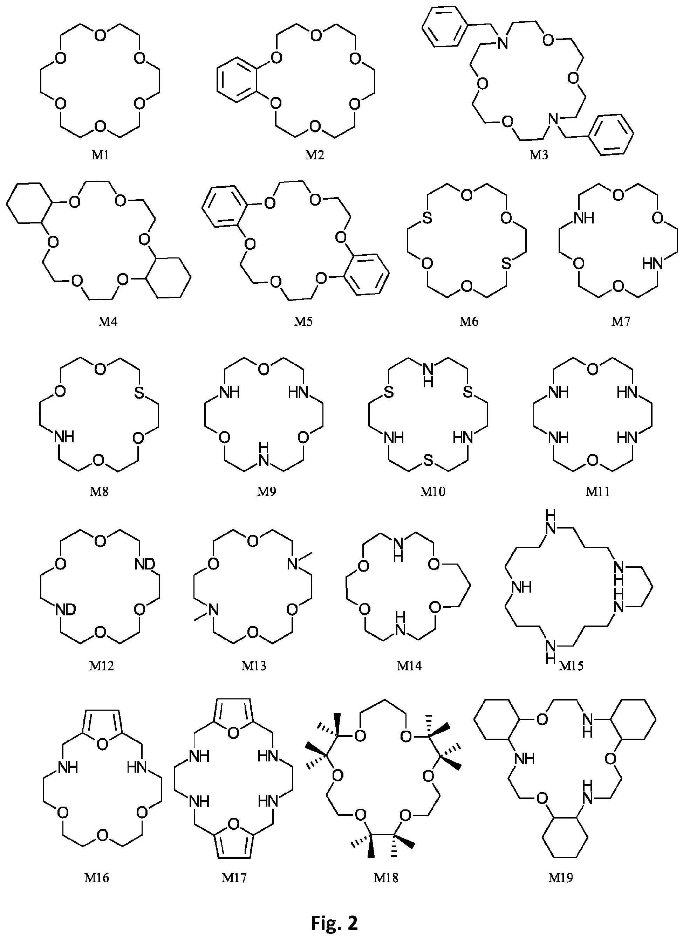

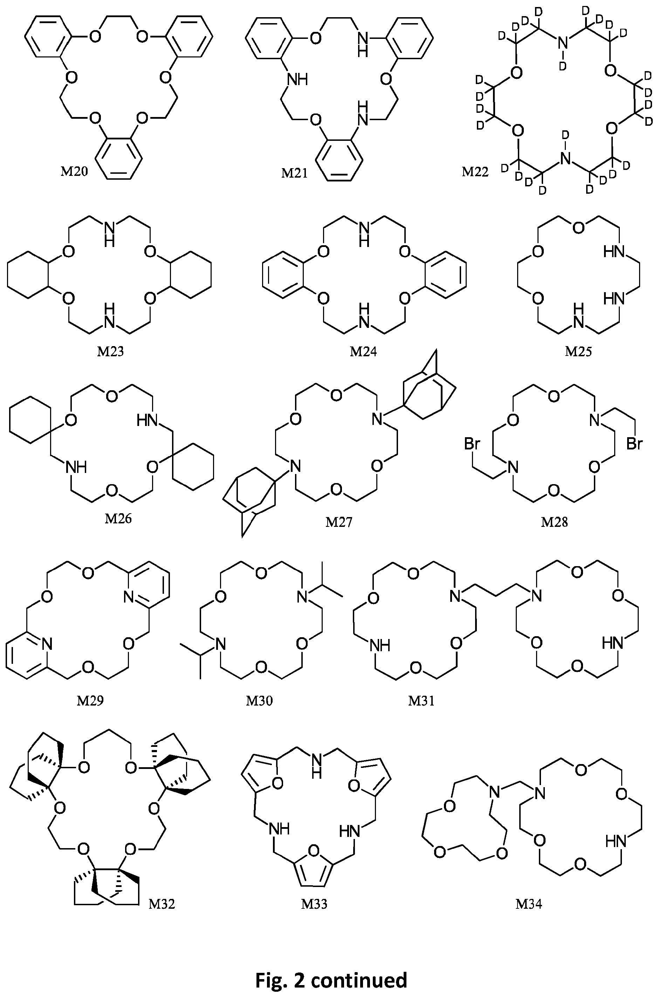

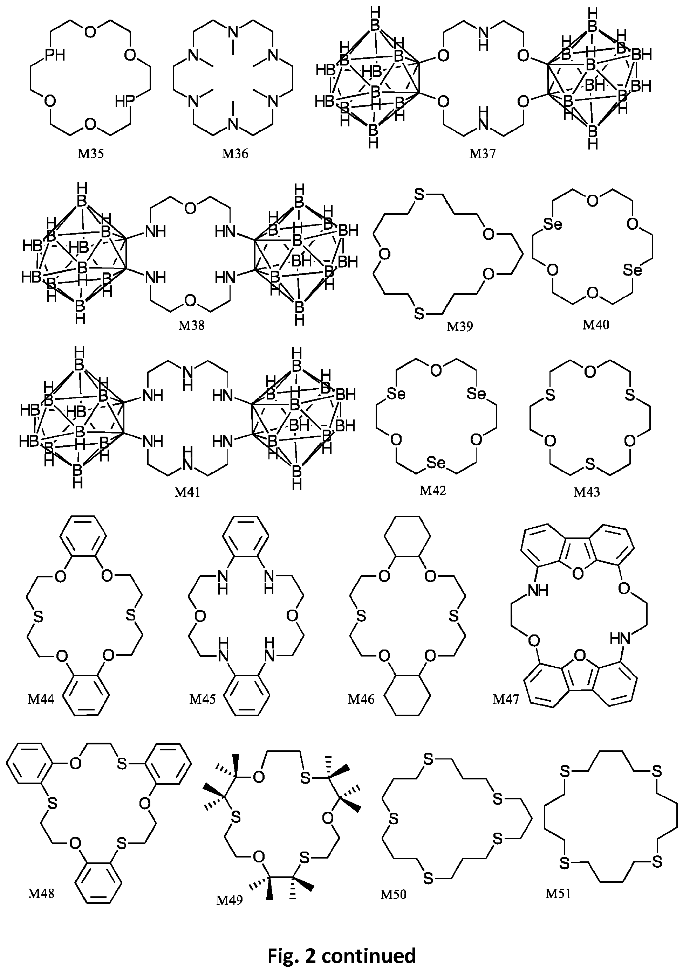

Any further ring structures, in the amount of one or several, in addition to the macrocycle, forming part of the macrocyclic organic ligand in addition to the macrocycle are preferably covalently linked with one macrocycle atom, or form part of the macrocycle by 1,2-, 1,3- or 1,4-annelation of the further ring structure, and are not additionally covalently linked with other atoms of the macrocycle. Examples can be furanyl inserted in the ring (see M16, M17, and M33 in Fig. 2), 1,2-cyclohexyl inserted in the ring (see M4, M19, M23, M32, and M46), 1,2-phenylene inserted in the ring (see M5, M21, M24, M44, M45 and M48), spiro compounds, like 1,1-cyclohexane (see M26), pyridine inserts in the ring (M29), other cyclic structure covalently linked with one macrocycle atom (M27, M38, M41). Also fused groups are possible, like dibenzofuran (see M47) there replacing 5 macrocycle atoms by the sequence C-C-O-C-C).

Therefore, the preferred macrocyclic organic ligand might be described by formula (1-1): 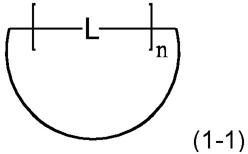 with n being 4 to 6, preferably 6; and L being independently in each occurrence a divalent organic group formed by removing two hydrogen atoms from an organic molecule containing at least two hydrogen atoms with the shortest sequence of atoms linking each L with the remainder of the macrocycle in the macrocyclic ligand being 2 to 4, preferably 3 or 4 atoms, and with one of those 2 to 5 atoms independently for each L being selected from the heteroatoms B, N, P, S, Se, Si or O, preferably N, S, Se or O, the other atoms of those atoms being carbon, wherein preferably the heteroatoms in the macrocycle are non-neighboring. Formula (1-1) describes macrocyclic organic ligands with a minimum of 12 and a maximum of 30 macrocyclic atoms in the macrocycle. In each instance of L, there is at least one heteroatom present. Thus, there are 4 to 30 heteroatoms preferably selected from N, P, O, S, or Se present that are able to coordinate to the divalent Europium. The linker L represents any (divalent) organyl group, such as, but not limited to, a linear (divalent) heteroalkane, a (divalent) heteroaryl, or any other (divalent) heterocyclic group. All those groups may be further substituted, for example, instead of a simple linear (divalent) heteroalkene, a branched (divalent) heteroalkene chain might be present. For (divalent) cyclic organyl groups, always the shortest sequence of atoms linking the (divalent) organyl group to the remainder of the ligand according to formula (1-1) shall constitute the macrocyclic atoms, i.e., should be 2 to 4, preferably 3 or 4 atoms. For example, if L represents a (divalent) furanyl group covalently connected to the remainder of the molecule in the 2,5 positions, then the shortest sequence of atoms is 3 and one oxygen is present. Similarly, if L represents a (divalent) pyrazinyl group covalently connected to the remainder of the molecule in the 2,6 positions, then the shortest sequence of atoms is 3 and one nitrogen is present. There is also a longer sequence of 5 atoms, which also has one nitrogen present, which, however, is not the shortest sequence of atoms according to the definition. Finally, an (divalent) aniline group connected via the 2,6 positions is considered. Again, the shortest sequence of atoms is 3, yet none of those 3 atoms is a heteroatom such as N, P, S, or O. The nitrogen present in aniline is not part of the shortest sequence of atoms in this situation, and as such this group does not fulfill the requirements of (1-1) and thus is not falling under the generic formula (1-1).

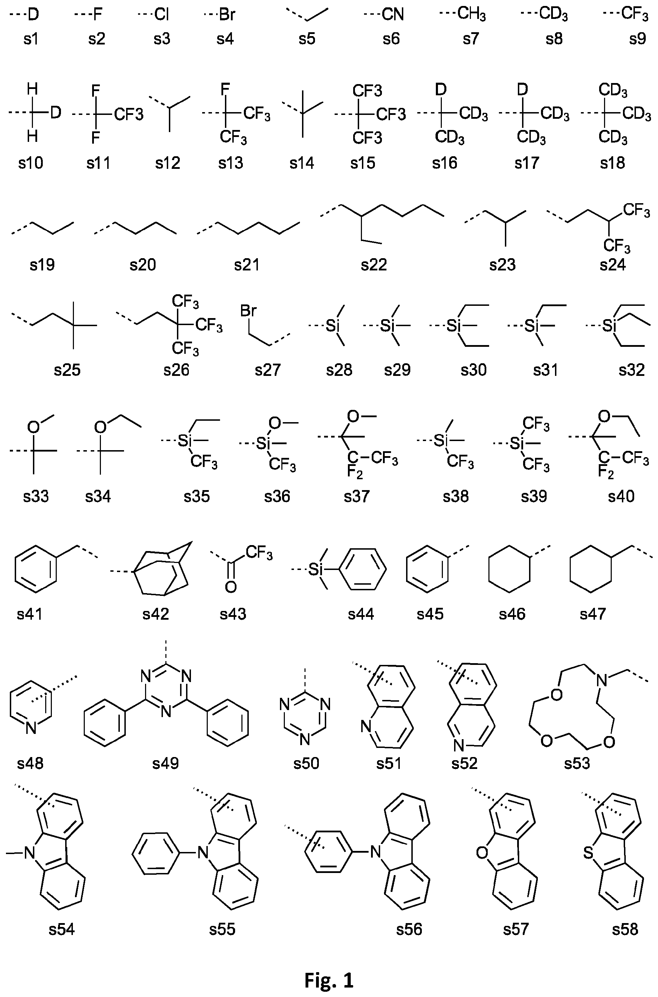

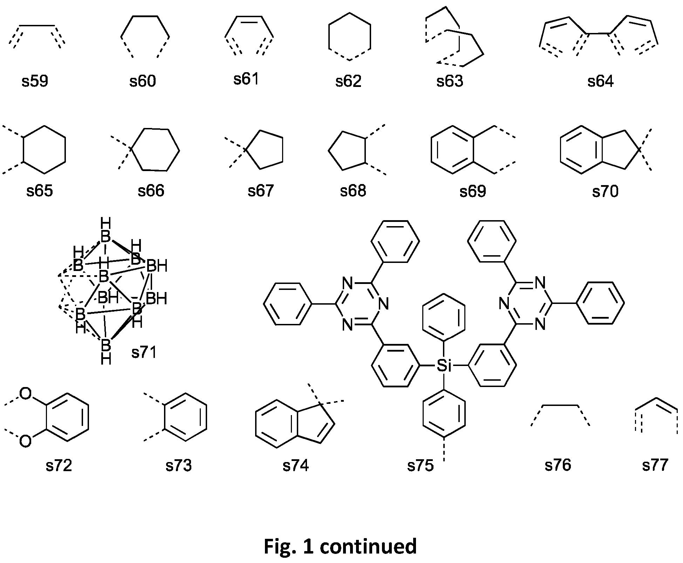

With respect to the generic formula (1-1), preference is generally given to n = 6 and for 3 atoms, for n = 5 and for 4 atoms, as well as to n=4 and for 5 atoms, being in the shortest sequence of L. Further preference is given to heteroatoms N, S, Se or O, being present as part of L. L might independently in each occurrence be selected from (2-1) to (2-5): 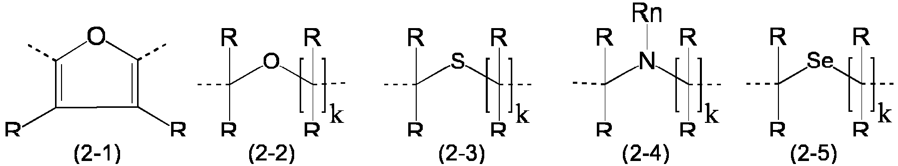 with R and **Rₙ** being H, D, or any covalently linked substituent being identical or different in each occurrence, k is independently in each occurrence 1 or 2 two to four instances of R present on neighboring carbon atoms independently in each occurrence may fuse, and the dashed lines indicating the covalent linkage to the remainder of the macrocyclic ligand according to formula (1-1). In each linker (2-1) to (2-5) the shortest sequence of atoms is exactly three and there is a heteroatom in the center of this sequence that is able to coordinate the central Europium. Generally, symmetrical linkers are preferred, i.e., where one macrocyclic coordinating heteroatom is sandwiched by two carbon atoms. Further preference is given to weakly polarizable and chemically robust units, in particular preference is given to (2-1), (2-2), and (2-4). In (2-1) to (2-5) positions for optional substitutions are indicated by R. R may be any suitable organyl group, formed by removing one hydrogen from an organic molecule containing at least one hydrogen atom, including, but not limited to, aryl, heteroaryl, or branched, cyclic or linear alkane or heteroalkene, halogens or deuterium, see groups s1 to s77 in FIG. 1, wherein a dash line represents the preferred connection point. Additionally, two instances of R present in the same or two different instances of L may link to each other to form a cyclic group. For example, two Rs present in (2-2) in the same instance of L on neighboring carbon atoms may link to each other to form a cyclohexane group. Similarly, two R groups present in (2-2) in the same instance of L on the same carbon atom may link to each other to form a spiro group. In this context (2-1) represents particular embodiment of the more general linker (2-2); the former ones can be constituted by linking 2 or 4 instances of R. In various embodiments, instances of R have 1 to 80 atoms. Yet, in other instances, it will be 1 to 30 atoms. R is generally charge-neutral.

Further preferred examples of macrocyclic ligands according to formula (1-1) are illustrated by the generic formulae (3-1) to (3-3): 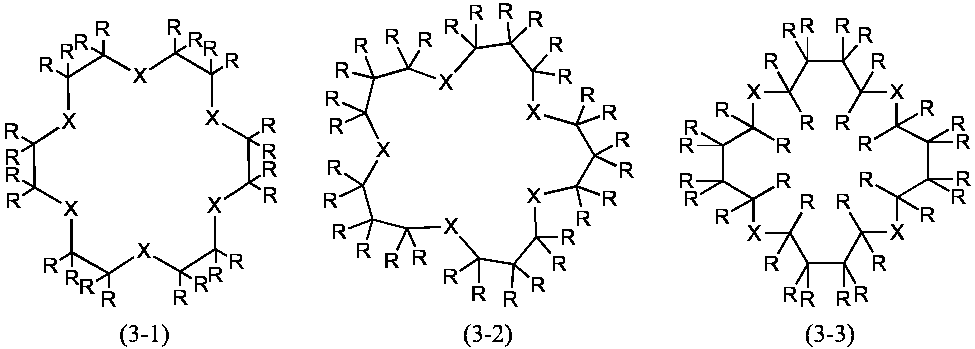 with **X** independently in each occurrence being N-Rn, S, Se, or O, and **R,** and **Rn** being identical or different in each occurrence and being H, D, or any covalently linked monovalent organic group formed by removing a hydrogen atom from an organic molecule containing at least one hydrogen atom, whereby two, three, or four instances of R being present on the same or neighboring carbon atoms can be fused.

All generic structures (3-1) to (3-3) feature 4 to 6 macrocyclic heteroatoms able to coordinate to divalent Europium. Those 4 to 6 heteroatoms are selected from O, S, N and Se. No two heteroatoms are direct neighbours, i.e., they are not linked directly by a chemical bond. Instead, all heteroatoms are separated from each other by two or three or four carbon atoms, i.e., by a linear ethylene or propylene or...chain segment. Therefore, the overall number of macrocyclic atoms present in structures (3-1) is 18, i.e., 12 carbon and 6 hetero atoms, the overall number of macrocyclic atoms in structures (3-2), is 20, i.e., 15 carbon and 5 hetero atoms, whereas the overall number of macrocyclic atoms in structures (3-3) is 20, i.e., 16 carbon and 4 hetero atoms. The R depicted in (3-1) to (3-3) again represent any organyl group formed by abstracting a hydrogen atom from a chemical stable group, formed by removing one hydrogen from an organic molecule containing at least one hydrogen atom, including, but not limited to, aryl, heteroaryl, or branched, cyclic or linear alkane or heteroalkene, halogens or deuterium, such as shown in Fig. 1. However, like above, the R should not be electrically charged. Therefore, metal-organic coordination compounds according to the invention that are based on the generic macrocyclic formulae (3-1) to (3-3) comprise two iodine anions to form a charge neutral coordination compound together with the divalent Europium.

If a good solubility in non-polar solvents is needed, the substituents R may be, but not limited to, linear or branched alkane or cyclic or alkoxy or halogenated side chains, such as, but not limited to, groups s19 to s47, shown in Fig. 1. For other applications, coordination compounds with high thermal stability, for example, suitable for evaporation or sublimation, may be needed. In this case, small and light weight substituents are preferably employed, i.e., organyl fragments with individually less than 20 atoms and or individually having a molecular weight of less than 100 g/mol, such as, but not limited to, groups s1 to ss21, s26 to s40, shown in Fig. 1. Similarly, halogenated side groups may improve volatility and/or stability of the coordination compound according to the invention, such as, but not limited to, groups s9, s11, s13, s15, s 24, s26, s27, s35 to s40, shown in Fig. 1. In case the intended application of the coordination compound of the invention is light generation, for example by electroluminescence, the ligand preferably may be chosen such that the excitation of the coordination compound is confined to the central Europium cation. In this way, an intrametallic transition with highest efficiency is obtained. With respect to the choice of the substituents, side groups that are not easily polarized and that have a sufficiently high triplet level above the transition of the first electronically excited state of the central divalent Europium are preferred. Low polarizability is ensured for aliphatic or heteroaliphatic substituents or using small aryl- or heteroaryl systems with less than 8 conjugated atoms or heteroatoms. In case heteroatoms are part of conjugated side groups, preference is generally given to the heteroatoms N and O, and even more preference is given to O. In various embodiments, side groups with a triplet energy > 2.5 eV, or preferably > 2.7 eV are used. Sufficiently high triplet energy of > 2.7 eV is generally observed for organyl groups comprising of aliphatic or heteroaliphatic fragments or for fragments comprising only small aryl- or heteroaryl systems with less than 8 conjugated atoms or heteroatoms, which thus should preferably be employed if a deep blue electroluminescent emitter is the intended use of the coordination compounds according to the invention. Today, triplet energies of organic molecules can easily and sufficiently accurately be calculated using a wide range of open source or commercial density functional theory (DFT) software packages. Alternatively, triplet energies can be experimentally probed for example as described in van Dijken, A., et al. "Carbazole compounds as host materials for triplet emitters in organic light-emitting diodes: polymer hosts for high-efficiency light-emitting diodes." Journal of the American Chemical Society 126.24 (2004): 7718-7727. As a simple rule, suitable high triplet energy building blocks of the macrocyclic organic ligand are preferably either non-aromatic (aliphatic) or comprise aromatic building blocks containing at most 8 aromatic carbon or hetero atoms, whereby various aromatic building blocks are being separated from each other by at least one nonaromatic carbon or heteroatom. In this context, the nitrogen and oxygen present in carbazole and dibenzofuran are considered a nonaromatic heteroatom.

Within the scope of the invention are two or more substituents R that link with each other which are present on neighbouring carbon or nitrogen atoms of the macrocycle or on carbon and/or nitrogen atoms of the macrocycle that are separated by on (further) atom of the macrocycle. Two R groups on neighbouring macrocycle carbon and/or nitrogen atoms can also be replaced by a double bond, as well as two R groups on a macrocycle carbon atom can form a double bond to a non-macrocycle atom. Preferred are such linkages for R groups situated on neighbouring macrocyclic carbon atoms. Two neighbouring carbon atoms will share a direct carbon-carbon bond. However, two neighbouring macrocyclic carbon atoms may as well be separated from each other by a single macrocyclic heteroatom. In this case, no direct carbon-carbon bond is present, yet those two macrocyclic carbon atoms are still nearest neighbours along the macrocyclic ring. There is a wide range of possibilities on how two or more R groups might be linked with each other, many of those are obvious to those skilled in the art. In one embodiment and based on (3-1), in one instance, two R groups being situated on neighbouring carbon atoms that are directly chemically connected may link with the divalent butane-based group s60 shown in Fig. 1, wherein dash lines here and in other places represent the covalent linkage, into a cyclohexane group resulting in a cyclohexyl-18-crown-6 macrocyclic ring. Along the same lines, 4 R groups being situated on two neighbouring carbon atoms might fuse with the tetravalent butene-based group s61, Fig. 1, into a benzene ring, resulting in a benzo-18 crown 6 macrocyclic ring, which is described by the generic structure (3-1). Such linkage can happen several times, for example, if 8 R groups on two separate ethyl linkers are fused into two benzene rings, one might arrive at dibenzo-18-crown-6, which is again based on the generic structure (3-1). In any case, additional non-fused substitutions R, for example a methyl group, i.e., the monovalent s5 group from Fig. 1, may be present. As said, also substituents on two carbon atoms that are separated by a single heteroatom may fuse. By example of (3-1), the two substituents on two carbon atoms separated by one of the 6 oxygens may link with the divalent ethane-based group s76 from Fig. 1, giving a tetrahydrofuran fragment as part of the macrocyclic ring. Similarly, 4 substituents on those two carbon atoms may link with the tetravalent group s64 shown in Fig. 1, to fuse into a furanyl group as a part of a dibenzofuran moiety. In any case, those fused organyl groups may be further substituted. As an example, a furanyl group may be further substituted with a non-macrocyclic trivalent propylene-based group s77 from Fig. 1 to fuse into benzene ring thus forming 2-benzofurane, being incorporated at the 1,3 positions into the macrocyclic ring. Similarly, the furanyl might be doubly substituted with two trivalent propylene-based groups s77 from Fig. 1 to fuse into a dibenzofuran fragment, being incorporated into the macrocyclic system at the 4,6 positions, such that 5 macrocyclic atoms are part of the dibenzofuran fragment.

The substitutions on the nitrogen are labeled Rn in in (2-4). Within the scope the invention, an instance of Rn may be fused with an instance of another substitution R from a carbon atom. However, outside the scope of the invention is a linkage of two instances of Rn with each other that are not covalently linked to two neighboring macrocycle atoms (thus in a 1,2-substitution scheme) or to two macrocycle atoms separated by one further macrocycle atom (thus in a 1,3-substitution scheme). Such linkages would often form highly three-dimensional cages, typical of the cryptand-type macrocyclic ligands, compare WO 2021/244801. Those ligands, in a combination with divalent europium and two iodide anions are often not able to form a symmetric structure thereby forming structures with high total dipole moment, and, as such, they are not well-suited for the design of volatile emitter molecules suitable for gas-transfer processing.

**FIG. 2** shows macrocyclic organic ligands M1 to M51, which further illustrate examples of metal-organic coordination compounds according to the invention. Eu₂⁺ and two idodide anions are always present as parts of the final metal-organic coordination compound according to the invention, however they are omitted and only the ligands are shown in Fig. 2 for clarity. The concrete compounds depicted serve for illustration purposes. In this context, most of the possible substituents that may be present on certain carbon or heteroatoms have been omitted for clarity. They may nevertheless be present.

The majority of examples depicted in FIG. 2 exemplifies macrocyclic organic ligands with 18 macrocyclic carbon and heteroatoms. Exceptions are compounds M51 with 16 macrocyclic atoms, M14 and M18 with 19 macrocyclic atoms, as well as M15, M39 and M50 with 20 macrocyclic atoms. Six heteroatoms are present in the majority of examples depicted in FIG. 2. Exceptions are examples M15, M39 and M50 exemplifying five heteroatoms and M51 exemplifying four heteroatoms. The heteroatoms are mostly selected from N, O, and S. Only M35, M40, and M42 are based on a 18-crown-6 motive with macrocyclic oxygens being replaced other heteroatoms: by two (M40), or three (M42) Se atoms, or by two P atoms (M35).

As explained above, any suitable macrocyclic carbon or heteroatom may be substituted using a suitable substituent. Here M1, M6 to M11, M14, M15, M25, M35, M39, M40, M42, M43, M50 and M51 are depicted without any substituents. M18 and M49 illustrate the situation where 6 macrocyclic carbon atoms are each twice substituted by a methyl group. M3, M13, M22, M27, M28, M30, M31, M34 and M36 depict various situations where two macrocyclic nitrogen's present in the organic ligand are substituted with linear (M28) or branched (M30) alkyl groups, benzyl (M3), or adamantyl (M27). In M12 and M22, the hydrogens present on the two nitrogen's are substituted by deuterium. For M31 and M34, one nitrogen is substituted with a linear chain attached to a cyclic aza-crown ether group, i.e., to another macrocyclic organic ligand.

For applications requiring high chemical stability, it may be beneficial to substitute hydrogen partly or completely by deuterium. For example, all possible hydrogens present in the macrocyclic ligand are replaced by deuterium in M22. On the other hand, in example M12, only the two most chemical reactive hydrogens present on the macrocyclic nitrogen atoms, are substituted by deuterium, s1 group from Fig. 1.

As explained above, several substituents present on the macrocyclic organic atoms may be linked to each other, and various examples are given in Fig. 2. For example, in M4, M23 and M46, two times two instances of R, and in M19, three times two instances of R, present on neighboring macrocyclic carbon atoms with a direct bond are linked with the divalent butane-based s60 group from Fig. 1 into cyclohexane fragments. M26 depicts the situation where two instances of R present on the same macrocyclic carbon atom are linked with s62 from Fig. 1 to fuse into the cyclohexane groups. Thus, the macrocyclic carbon atom is spiro-linked to its two substituents. In the case of M32, two times two instances of R present on neighboring macrocyclic carbon atoms with a direct bond are linked with s63 from Fig. 1 into bis-cyclic aliphatic groups; overall this substitution pattern appears 3 times in M32, thus a total of 12 hydrogens are substituted. Similarly, in M5, M20, M21, M24, M44, M45 and M48, two (M5, M24, M44 and M45) or three (M20, M21, and M48) times four instances of R fuse with tetravalent butene-based groups s61 from Fig 1, into a benzene fragment, with four or six macrocyclic carbon atoms being now aromatic. In M16, M17, and M33, four substituents on two neighboring macrocyclic carbon atoms without a direct bond, i.e., separated by a heteroatom, fuse with tetravalent ethane-based groups s59 from Fig. 1. Here furanyl is formed with the oxygen and the two substituted carbon being macrocyclic ring atoms. In the case of M29, four substituents on two neighboring macrocyclic carbon atoms separated by nitrogen are linked with trivalent propylene-based group s77 to form pyridine groups, and nitrogen and the two substituted carbon atoms are parts of the macrocyclic ring. In case of M47, benzene and furan forming substituents are combined thus forming di benzofuran with 5 atoms of the di benzo furan being macrocyclic ring atoms. In this particular example, 16 substituents are not equal to hydrogen. In the case of M37, M38 and M41, two times two instances of R present on neighboring macrocyclic carbon atoms with a direct bond are linked with s71 from Fig. 1 to form ortho-carborane (C₂B₁₀H₁₂); overall this substitution pattern appears 2 times in those M37, M38 and M41; thus, in each macrocycle, a total of 8 hydrogens are substituted.

"The macrocycle" refers to only the sequence of atoms forming the ring core around the Eu(II). "The macrocyclic organic ligand" includes the macrocycle and adds hydrogen or substituents to the remaining free valencies of the macrocycle atoms. In all examples of coordination compounds utilizing ligands M1 to M51, shown in Fig. 2, two identical anions, i.e., iodide anions are present. The coordination compound according to the invention is mixed with a second charge-neutral (electrically neutral) organic compound. The second organic material may be chosen from a wide range of generic classes of substantially organic materials, including, but not limited to, small organic molecules, preferably with a molecular weight less than 1500 g/mol, large molecules or polymers with organic weight of more than 1500 g/mol, dendrimers, metal-organic complexes, or organic materials not comprising any metals. Generally, the second organic material may also be processed in a low molecular weight form and later be combined into a higher molecular weight form. Examples here are metal-organic frameworks, or crosslinkable polymers. Generally preferred are second organic materials that add a desired functionality to the mixture comprising the metal-organic coordination compound according to the invention. Such a functionality can be, without limitation, improved air or moisture stability, improved thermal stability, improved charge transport ability, improved dispersion of the coordination compound according to the invention, improved optical characteristics - such as lowering the refractive index of the mixture, improved processing, to name just a few.

In various embodiments, the coordination compound is imbedded into the at least one second charge-neutral organic compound at 0.1 - 99.0 vol%, preferably at 1 - 90 vol%, and most preferably at 3 - 30 vol%, based on the mixture which is 100 vol%. Thus, in various embodiments, the coordination compound might take a majority or a minority of the overall volume of the mixture. Yet, in a more preferred embodiment, the coordination compound takes a minority part of the volume and has the function of an organic dopant, whereas the one or more second organic materials take a majority part of the volume, for example to funnel energy or charges towards the coordination compound.

The combination of unique emission properties with the ease of processing makes the coordination compounds according to the invention (i.e., based on divalent Europium in combination with iodide anions), highly attractive for application in organic electronic devices. In this description, an organic electronic device may be any device or structure including substantially organic layers or subunits, where an electro-magnetic stimulus may be converted into an electrical field or current or vice versa, or where an input electrical current or electrical field may be used to modulate an output electrical current or electrical field.

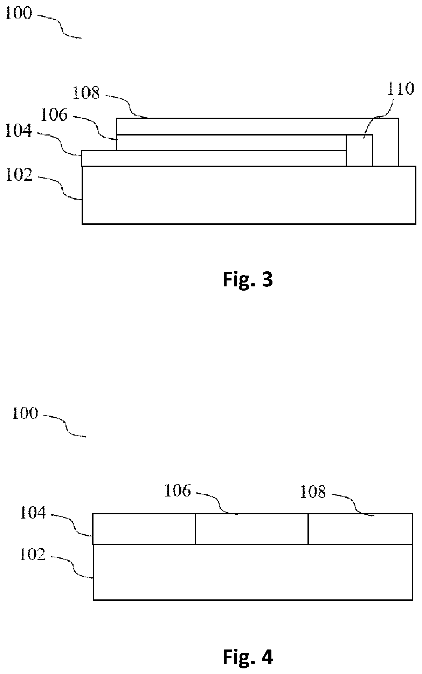

**FIG. 3** and **FIG. 4** illustrate embodiments of an organic electronic device 100 configured as optically active device. The organic electronic device may include a first electrode 104, e.g., on a substrate 102 or as the substrate; a second electrode 108; and an organic layer 106 arranged such that it is electrically interposed between the first and second electrodes 104, 108. The first and second electrodes 104, 108 may be electrically insulated from each other by an insulating structure 110, e.g., a resin or polyimide. The first and second electrodes 104, 108 may be stacked over each other (FIG. 3) or may be arranged in a common plane (FIG. 4).

The organic layer 106 may include the coordination compound according to any of the described or illustrated embodiments, e.g., the layer may contain just the coordination compound, or a mixture with a further organic or non-organic material.

In various embodiments, the organic electronic device 100 may be an optoelectronic device, the optoelectronic device being at least one of an organic light emitting diode (OLED), a light emitting cell (LEC), an organic photodetector, or a photovoltaic cell. That is, photons from an external electromagnetic field may be absorbed in the organic layer 106 and converted into current by means of an electrical field between the first and second electrodes 104 and 108. Such a device would be a photodiode (OPD), and its primarily use may be to sense external light. It would be an organic photovoltaic (OPV) device if the primarily use is to convert light into current.

The organic layer 106 is arranged electrically between the first and second electrodes 104 and 108, such that an electronic current may flow from the first electrode 104 through the organic layer 106 to the second electrode 108 and vice versa during operation, e.g., in light emission applications. Alternatively, in photoelectric applications, a charge carrier pair may be formed in the organic layer 106 and charge carriers of the charge carrier pair may be transported to the first and second electrodes 104 and 108, respectively. In other words, in light emission applications, upon application of sufficient voltage, holes and electrons are injected from the anode and the cathode, respectively. From there, they drift towards the organic layer 106, where charges of opposite sign recombine to form a short-lived localized excited state. The short-lived excited state may relax to the ground state thereby giving rise to light emission.

The first and second electrodes 104, 108 may be substantially unstructured layers, e.g., for general lighting applications, or may be structured, e.g., for light emitting diodes or transistors for pixels in a display application.

The organic electronic device 100 may be configured to emit substantially monochromatic light, such as red, green, blue, or polychromatic light such as white. The light may be emitted through the first electrode 104 (bottom emitter), through the second electrode 108 (top emitter), or through first and second electrodes 104 and 108 (bidirectional emitter). The light may as well be emitted substantially in a direction parallel to the organic layer 106 using suitable opaque electrodes 104 and 108. In such a layout, lasing may be achieved, and the device may be an organic laser, which, in this description, may be considered as a specific type of electroluminescent devices.

The coordination compounds according to various embodiments may have excellent emission properties, including a narrow, deep blue emission spectrum with short excited state lifetime. Given their high atomic weight and open shell septet multiplicities, the optical transition of Eu₂⁺ may be as well widely indifferent to excitation with either spin 1 or spin 0 electron-hole pairs. In other words, singlet and triplet excitations are harvested, resulting in high light emission efficiency. As such, the coordination compounds according to various embodiments may be ideally suited for application in organic electroluminescent devices, such as organic light emitting diodes (OLED). In this description, an electroluminescent device may be any device including an organic layer disposed between and electrically connected to an anode 104/108 and a cathode 108/104. Upon application of sufficient voltage, holes and electrons may be injected from the anode 104/108 and the cathode 108/104, respectively, and drift towards the organic layer 106, where charges of opposite sign recombine to form a short-lived localized excited state. The short-lived excited state may relax to the ground state thereby giving rise to light emission. Relaxation pathways without light emission, such as thermal relaxation, may be possible too, but may be considered undesirable, as they lower the conversion efficiency of current into light of the device. Organic light emitting cells (LECs) may be considered as a subclass of OLED devices comprising of mobile charged species inside the active organic layer 106, which are able to drift inside an external applied electrical field. As such OLEDs encompass LEC type devices.

Further layers may be formed and in electrical connection between the first and second electrodes 104, 108, e.g., configured for charge carrier (electron or hole) injection, configured for charge carrier transport, configured for charge carrier blockage or configured for charge generation. Further optically functional layers, e.g., a further electroluminescent material and/or a wavelength conversion material may be formed electrically between the first and second electrodes 104, 108 and in the optical path of the organic layer 106, e.g., on top of the second electrode 108 and/or on the opposite side of the substrate 102. In addition, encapsulation structures may be formed encapsulating the electrically active area, e.g., the area in which electrical current flows and may be configured to reduce or avoid intrusion of oxygen and/or water into the electrically active area. Further optically functional layers, e.g., an antireflection coating, a waveguide structure and/or an optical decoupling layer may be formed within the optical light path of the organic layer 106.

As example, hole or electron blocking layers may be used to optimize the individual hole and electron currents through the organic electronic device 100. This may be known to those skilled in the art as charge balance in order to optimize efficiency and operational stability. In various embodiments, dedicated hole or electron charge transport layers may be present in the organic electronic device 100 to space the emission region from the first and second electrodes 104, 108.

Examples of hole transport materials include known materials such as fluorene and derivatives thereof, aromatic amine and derivatives thereof, carbazole derivatives, dibenzofuran, dibenzothiophene, and polyparaphenylene derivatives. Examples of electron transport materials include oxadiazole derivatives, triazine derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and its derivative, diphenoquinone derivatives, and metal complexes of 8-hydroxyquinoline and its derivatives and various derivatives of silanes.

In various embodiments, those charge transport layers may include electrical dopant molecules or metals or may be in contact to charge injection layers. Any of those auxiliary layers may be fully organic or may include inorganic functional moieties. For example, charge transport layers may be made of the class of Perovskite materials.

The coordination compound according to the invention as illustrated or described in any one of the embodiments may be used as a thin substantially organic emission layer 106 of any thickness in the range of 0.1 to 100 nm, preferably in the range of 3 to 20 nm.

A second organic material being present in the layer containing the coordination compound according to the invention such as the organic layer 106 may in various embodiments be a charge transport material to improve charge transport into and through the organic layer 106 or to facilitate charge recombination. Charge transport materials may be any material that are able to transport either holes or electrons or both types of charges upon applying a suitable electrical field. In particular, a charge transport material may be any aryl, or heteroaryl organic compound or any metal complex or any mixture thereof. Without limiting the scope of the invention, examples of materials present in the light emitting layer 106 include carbazole derivatives, including carbazole-phosphine oxide materials, oxadiazole derivatives, triazine derivatives, silane derivatives and any other material or combination of materials with sufficiently high triplet level that may transport charges or otherwise benefit the device performance.

In various embodiments, the second organic material (b) may serve as charge transporting host to enable electrical excitation of the coordination compound (a) present in the mixture according to the invention. To achieve this desired functionality without severely compromising the triplet energy level, the second charge-neutral compound in preferred embodiments comprises (hetero)arene fragments derived from benzene, pyridine, pyrrole, furan, carbazole, dibenzofuran, triazine, triazole, or benzofuran by removing one or two hydrogen atoms.

In various alternative embodiments the second charge-neutral compound (b) has a molecular weight Mₙ above 1000 g/mol, and the coordination compound (a) and the second charge-neutral compound (b) are chemically linked with each other, for example by a covalent or coordinative chemical bond. Here the mixture is a polymeric compound, which might have benefits in terms of very high glass transition temperatures, or it may ease the processing of the mixtures using wet solution techniques.

The organic layer 106 that contains the coordination compound according to the invention may contain any further organic or inorganic material in a range of 0.1 to 99.0 vol% that is not intended to transport charges. For example, the organic layer 106 may include polymers (in a mixture or as a compound) which may be added to improve film quality and prevent crystallization. Other materials may be added to evenly space the coordination compound inside the organic layer 106.

In various embodiments, the organic electronic device 100 includes two or more subunits each including at least one light emitting layer. The subunits may be stacked over each other physically separated and electrically connected by a charge generation layer or, alternatively, may be arranged side by side. The subunits may be subpixels of a pixel in a display or general lighting application. The light emitted by the subunits may be mixed to generate a light of a predetermined color. Each subunit may emit light of the same or a different color. The overall light emitted by such organic electronic device 100 may contain a narrow spectral region, such as blue, or may contain a wide spectral region such as white, or a combination thereof. The coordination compound according to the invention comprising the divalent Europium illustrated or described in any one of the embodiments may or may not be present in each individual subunit of the organic electronic device 100.

In various embodiments, the light emitted by the organic electronic device 100 may be in optical contact to at least one optically active layer, including any optically active materials such as organic molecules or quantum dots. The optically active layer may be a spectral filter element, which may absorb part of the light emitted by the organic electronic device 100. In another embodiment, the optically active layer may absorb at least part of the light emitted by the organic electronic device 100 and may reemit it at longer wavelength (wavelength conversion), e.g., by quantum dots. As an example, the organic layer 106 may be configured to emit light substantially at wavelengths shorter than 500 nm and the optically active layer may be configured to substantially reemit light at wavelengths longer than 500 nm. The optically active layer may be placed in between the anode and cathode of the organic electronic device 100 or outside of it. The optically active layer may as well be part of the organic layer 106.

The term "substantially" may refer to (relative) amounts of a compound and typically means at least 80 wt% preferably at least 90 wt%, more preferably at least 95 wt%, specifically 100 wt%, not considering impurities or additives. It may define ranges of 80 to 100 wt% etc. for the content or purity of a compound. This definition refers e.g., to amounts like weight or volume or other parameters like wavelength. For single values, "substantially" allows for a variation or deviation from a given number by 20% or less, preferably 10% or less, more preferably 5% or less, specifically 1% or less. An emission substantially in the deep blue spectral region below 500 nm means that at least 80% of the emission are below 50 nm etc., e.g., of a measured integral of the emission intensity over wavelength. A substantially organic substrate contains at least 80% of organic substances. When not indicated otherwise, % means wt%.

The organic electronic device 100 may be configured as a large area OLED device used for illumination, signage, or as a backlight. Alternatively, the organic electronic device 100 may include a plurality of OLEDs arranged in a pixelated layout (plurality of OLED pixels) that are individually connected electrically, e.g., for flat panel display applications. Here, individual pixels may have the capability of emitting light of substantially narrow spectral portions; especially of red, green, and blue. The mixture may or may not be present in any of the individual pixels.

In another embodiment, the individual pixels may be configured to emit white light. Red, green, and blue spectral portions are generated by using suitable filter elements in optical contact with the respective pixelated OLEDs.

In another embodiment, the OLED pixels emit blue light, and the red and green spectral portions may be generated by using a suitable color conversion element in optical contact with the OLED pixels.

In another embodiment, the OLED pixels emit substantially in the near-UV spectral region with wavelength <450 nm and the red and green and blue spectral portions may be generated by using a suitable color conversion element in optical contact with the OLED pixels.

An organic electronic device 100 according to various embodiments may be fabricated using a wide range of commonly used techniques, including, but not limited to, deposition of all or some layers, from gas phase vacuum deposition, solution phase, or gas phase using a carrier gas method.

Due to the arrangement of the anions with respect to the cationic metal center, metal-organic coordination compounds according to the invention show a relatively low dipole moment allowing for thermal deposition from gas phase with high yields. Thus, in various embodiments, deposition via the gas phase in vacuum may be used, whereby the coordination compound may either undergo sublimation or evaporation and may be co-deposited with a second organic materials thereby forming mixed layers. The coordination compounds according to the invention show an improved sublimation/evaporation yield. The transfer into the gas phase may be further improved by using a carrier gas technology, whereby an inert gas that may not be deposited into the organic layer comprising the coordination compound assist the sublimation or evaporation of the coordination compound. During the deposition process from gas phase, the coordination compound may be co-deposited with a second organic material using two separate thermal sources, in other words, a mixture is formed in-situ during deposition. During such co deposition two or more additional materials may be deposited using a triple or quadruple evaporation, whereby the coordination compound according to the invention is further diluted. Alternatively, the metal-organic complex according to the invention may as well be thermally processed from one crucible. In other words, a mixture or a precursor thereof is already present before sublimation or evaporation. A precursor may for example be an additional auxiliary ligand present as part of the coordination compound that dissociates during thermal evaporation and that is substantially not built into the organic layer comprising the coordination compound according to the invention. Preferred in this situation are similar volatilities for the second organic material and the coordination compound. Alternatively, the coordination compound and the second organic material may form a frozen glass, thereby forcing the individual components to sublime at similar temperatures.

Another preferred technique to fabricate layers including the coordination compound according to various embodiments may be deposition from a liquid phase using a mixture of or a single organic solvent, whereby the coordination compound according to various embodiments may be dissolved or forms a suspension within the organic solvent; in this description may be referred to as the ink. The ink using this deposition process may include a wide variety of other materials apart from the coordination compound according to various embodiments to allow fabrication of triple or higher-order mixed layers from solution. Additives within the ink may for example, but may not be limited to, be organic or inorganic materials capable of transporting charges, materials that improve the film formation, materials that improve the distribution of the coordination compound according to the invention within a third material, organic or inorganic materials that improve the efficiency of the device, e.g., by reducing the refractive index. The deposition from solution may not be limited to any specific technique. Examples of the deposition from solution include spin coating, casting, dip coating, gravure coating, bar coating, roll coating, spray coating, screen printing, flexographic printing, offset printing, inkjet printing. Owning to their low dipole moments, the improved solubility of the coordination compounds according to the present invention in non-polar solvents eases the deposition from solution and makes it advantageous. In particular, solvents with relatively low polarity index such as tetrahydrofuran or toluene may be used as part of the ink formulation.

Various post processing techniques may be applied to improve the performance or stability of the organic electronic device. In one embodiment, some or all layers of the organic electronic device include functional groups capable of chemically crosslinking upon thermal or electromagnetic exposure thereby forming larger covalently bound molecules with improved physical properties. In another embodiment functional groups are present in a second organic material and after crosslinking the second organic material becomes a polymer with the coordination compound according to the invention being embedded into. In yet another embodiment functional groups capable of crosslinking are present on both, the coordination compound and a second organic material, and after crosslinking, a single polymeric material covalently linking a second organic material with the metal-organic coordination compound according to the invention is formed.

In various embodiments, the coordination compound may be formed in-situ using deposition from solution. Here, the organic macrocyclic ligand of the present invention, excluding the divalent Europium, may first be deposited onto a suitable substrate or other organic layer thereby forming a seed layer. Any suitable technique may be used to fabricate this seed layer. This seed layer, including the organic ligand, may include any further material. Preferred may be further additional inert organic or inorganic materials that aid the layer formation or improve its thermal stability or improve the distribution of the organic ligand or second organic material within this seed layer. In a next deposition step and sequential to forming the seed layer including the organic macrocyclic ligand excluding the metal, a layer including a molecular salt comprising the divalent Europium may be fabricated using a solution process. The Europium compound may be any charge neutral compound including Eu(II) and one or two suitable anions. The two suitable anions are preferably iodide or precursors thereof. The ink including the Europium compound may as well include one or more additives to fabricate mixed layers. These additives may be organic or inorganic materials to aid charge transport, may be organic or inorganic materials that improve the efficiency of the device, or may be any material that improves the film formation. At the interface of the seed layer including the organic ligand according to the invention, the solubilized divalent Europium compound will interact with the macrocyclic organic ligand to form the coordination compound according to various embodiments in-situ. Alternatively, the process of first forming the layer containing the ligand and secondly processing the lanthanide compound may be inverted.

For one or more aspects, at least one of the components set forth in one or more of the preceding figures may be configured to perform one or more operations, techniques, processes, and/or methods as set forth in the example section below.

### EXAMPLES

The examples set forth herein are illustrative and not exhaustive.

### Synthesis of various divalent Europium coordination compounds

All experimental manipulations were carried out under an inert atmosphere. Tetrahydrofuran (Acros Organics, extra dry, AcroSeal) was dried and distilled from K/benzophenone or purchased as anhydrous from Acros Organics. Toluene (Acros Organics, Extra Dry, AcroSeal) purchased as anhydrous from Acros Organics, Methanol (Acros Organics, Extra Dry, AcroSeal) purchased as anhydrous from Acros Organics. Europium(ll) iodide, Europium(II) bromide and Europium(II) chloride (Aldrich, AnhydroBeads, 10 mesh, 99.999% trace metals basis) were used as purchased. 1,4,7,10,13,16-Hexaoxacyclooctadecan (Aldrich, 99%), 2,3,11,12-dibenzo-1,4,7,10,13,16-hexaoxacyclooctadeca-2,11-dien (Aldrich, 98%), 1,4,10,13-Tetraoxa-7,16-diazacyclooctadecan (Aldrich, ≥96%) and 1,4,7,14,17,20-hexaoxa[7.7]orthocyclophan (Aldrich, 98%) were sublimated before the use. 6,9,12-trioxa-3,15-diaza-1(2,5)-furanacyclohexadecaphane was prepared according to a published procedure (dx.doi.org/10.1021/jo501966q | J. Org. Chem. 2014, 79, 10334-10341).

### Synthesis of bis[bis(trimethylsilyl)amide]bis(tetrahydrofuran) europium(II) (Eu(HMDS)₂)

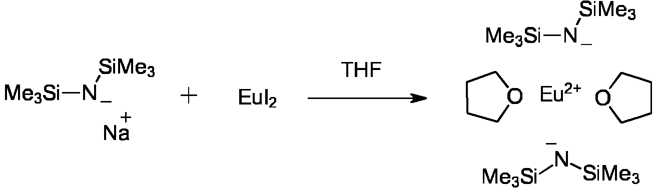

**Synthesis of bis[bis(trimethylsilyl)amide]bis(tetrahydrofuran)europium(II) (Eu(HMDS)2).** Sodium bis(trimethylsilyl)amide (2 eq, 9.5 g, 49.2 mmol) was added under a nitrogen atmosphere to the solution of europium diiodide (1 eq, 10 g, 24.6 mmol) in 300 ml of anhydrous THF. The mixture was stirred at RT overnight. THF was removed in vacuum and residue was extracted with hexane (250 ml). The extract was filtered and concentrated to ca. 50 ml volume. Cooling of the solution to 0°C resulted in precipitation of the title product as orange-yellow crystals. Yield: 90% (13.77g)

### Synthesis of trimethylammonium tetraphenylborate

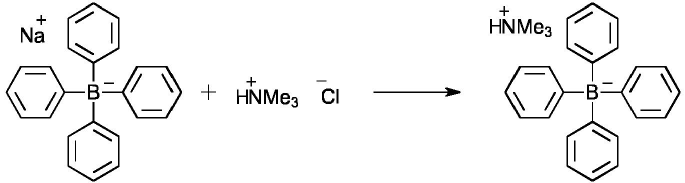

**Synthesis of trimethylammonium tetraphenylborate.** The solution of trimethylamine hydrochloride (1.1 eq, 1.08 g, 11.3 mmol) in 10 ml of deionized water was dropwise added to the solution of sodium tetraphenylborate (1 eq, 3.52 g, 10.3 mmol) in 50 ml of deionized water. The white precipitate was separated by suction filtration, washed with deionized water and dried in vacuum at 75 °C overnight. Yield: 3.2 g (81.9 %)

### Synthesis of europium(II) tetraphenylborate

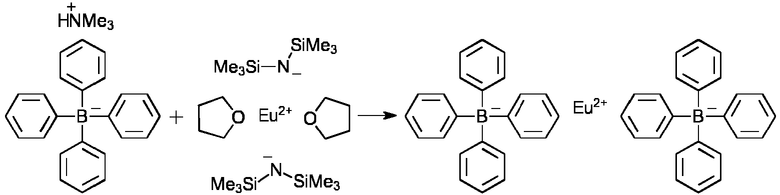

**Synthesis of europium(II) tetraphenylborate.** A solution of 2.00 mmol (2.0 eq., 759mg) trimethylammonium tetraphenylborate in 25 ml THF was dropwise by 60 °C treated with a solution of 1.00 mmol (1.0 eq., 617 mg) europium(II) bis[bis(trimethylsilyl)amido]bis(tetrahydrofuran)europium in 20 ml THF. The resulting suspension was stirred for 1 h at room temperature and then filtrated. The resulting powder was washed with THF and hexane and dried under reduced pressure. Yield: 54 %.

### Comparative examples: Synthesis of europium(II) 1,4,10,13-tetraoxa-7,16-diazacyclooctadecan tetraphenylborate (CE-1)

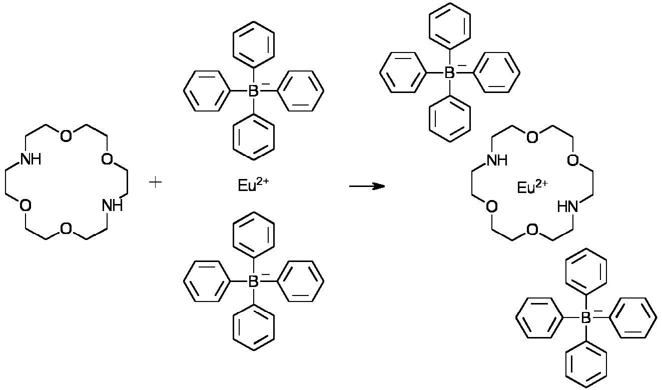

**Synthesis of europium(II) 1,4,10,13-tetraoxa-7,16-diazacyclooctadecan tetraphenylborate (CE1 in Table 1).** A solution of 0.29 mmol (1.0 eq., 77mg) of 1,4,10,13-tetraoxa-7,16-diazacyclooctadecan in 10 ml MeOH was added dropwise to a solution of 0.29 mmol (1.0 eq., 273 mg) europium(II) tetraphenylborate in 10 ml MeOH. The resulting suspension was stirred for 1 h at room temperature and then filtrated. The resulting powder was washed with MeOH and hexane. Yield: 290 mg (83 %). When attempting to sublimate, the compound decomposed.

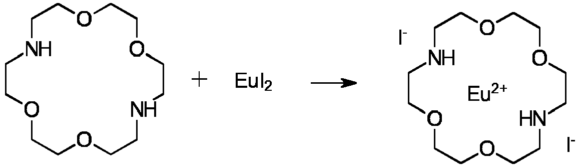

**Synthesis of europium(II) 1,4,7,10,13,16-Hexaoxacyclooctadecan iodide (M1).** A solution of 0.91 mmol (1.0 eq., 368mg) europium(II) iodide in 11 ml THF was added dropwise to a solution of 0.91 mmol (1.0 eq., 240mg) of 1,4,7,10,13,16-hexaoxacyclooctadecan in 20 ml THF. The resulting suspension was stirred for 1 h at room temperature and then filtrated. The resulting powder was washed with THF and dried in vacuum at room temperature. Yield: 501 mg (82.3 %).

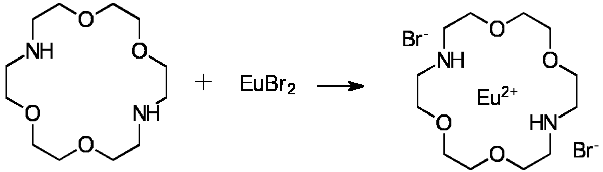

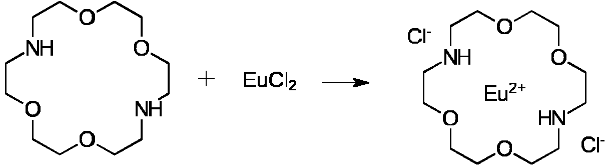

Europium(II) 1,4,7,10,13,16-hexaoxacyclooctadecan bromide (CE2) and europium(ll) 1,4,7,10,13,16-hexaoxacyclooctadecan chloride (CE3) were synthesized analogously to M1 from 1,4,7,10,13,16-hexaoxacyclooctadecan and EuBr₂ and EuCl₂, respectively. Yields and analytical data are given in Table2.

Europium(II) 2,3,11,12-dicyclohexano-1,4,7,10,13,16-hexaoxacyclooctadecane iodide (M4), Europium(II) 2,3,11,12-dibenzo-1,4,7,10,13,16-hexaoxacyclooctadeca-2,11-dien iodide (M5), Europium(II) 6,9,12-trioxa-3,15-diaza-1(2,5)-furanacyclohexadecaphane iodide (M16), were synthesized analogously from respective crown ethers and Europium(II) iodide. Yields and analytical data are summarized on **Table 1.**

**Table 1: Summary of the analytical data (sublimation, ESI-MS, and elemental analysis) of the prepared compounds.**

| Nr. | Name | Yield, % | Sublimation pressure/ temperature/ yield | ESI-MS, m/z | Elemental Analysis |
|---|---|---|---|---|---|
| CE1 | **Europium(II) 1,4,10,13-tetraoxa-7,16-diazacyclooctadecane tetraphenyl borate** | | *The substance didn't sublimate, but decomposed at 200-360 °C* | | |
| CE2 | **Europium(II) 1,4,10,13-tetraoxa-7,16-diazacyclooctadecane bromide** | 91 | 8.6E-7 mBar/ 235°C/ 34% | 494.3 (M - Br⁻)⁺; 285.4 (free crown + Na⁺)⁺; 263.4 (free crown + H⁺)⁺; 239.6 (M - 2 Br + 2MeOH)²⁺; 223.7 (M - 2 Br + MeOH)²⁺; 207.8 (M - 2 Br⁻)²⁺ | Calc.: C, 25.10; H, 4.56; N, 4.88. |
| | | | | | Found.: C, 24.89; H, 4.64; N, 4.85 |
| CE3 | **Europium(II) 1,4,10,13-tetraoxa-7,16-diazacyclooctadecane chloride** | 74 | *The substance didn't sublimate, but decomposed at 200-360 C* | 450.4 (M - Cl⁻)⁺; 263.4 (free crown + H⁺)⁺; 223.7 (M - 2 Cl⁻ + MeOH)²⁺; 207.7 (M - 2 Cl⁻ )²⁺ | |
| M1 | **europium(II) 1,4,7,10,13,16-Hexaoxacyclooctadecane iodide** | 82 | 1.66E-6 mBar/ 250°C/ 63% | 544.3 (M - I⁻)⁺; 340.9 (Eu²⁺ + 2 free crowns)²⁺; 287.4 (free crown + Na⁺)⁺; 240.8 (M - 2 I⁻ + 2MeOH)²⁺; 224.7 (M - 2 I⁻ + MeOH)²⁺ | Calc.: C, 21.51; H, 3.61; N, 0.00. |
| | | | | | Found.: C, 21.43; H, 3.59; N, 0.00 |
| M7 | **Europium(II) 1,4,10,13-tetraoxa-7,16-diazacyclooctadecane iodide** | 94 | 1.66E-6 mBar/ 240°C/ 94% | 542.4 (M - I⁻)⁺; 285.4 (free crown + Na⁺)⁺; 263.4 (free crown + H⁺)⁺; 239.6 (M - 2 I⁻ + 2MeOH)²⁺; 223.7 (M - 2 I⁻ + MeOH)²⁺ | Calc.: C, 21.57; H, 3.92; N, 4.19. |
| | | | | | Found.: C, 21.54; H, 3.86; N, 4.19 |
| M4 | **Europium(II) 2,3,11,12-dicyclohexano-1,4,7,10,13,16-hexaoxacyclooctadecane iodide** | 81 | 3.78E-6 mBar/ 230°C/ 57% | 652.5 (M - I⁻)⁺; 449.2 (Eu²⁺ + 2 free crowns)²⁺; 395.5 (free crown + Na⁺)⁺; 294.9 (M - 2 I⁻ + 2MeOH)²⁺; 278.9 (M - 2 I⁻ + MeOH)²⁺ | Calc.: C, 30.87; H, 4.66; N, 0.00. |
| | | | | | Found.: C, 30.66; H, 4.88; N, 0.00 |
| M5 | **Europium(II) 2,3,11,12-dibenzo-1,4,7,10,13,16-hexaoxacyclooctadeca-2,11-dien iodide** | 92 | *The substance didn't sublimate, but decomposed at 300 °C* | 640.4 (M - I⁻)⁺; 437.1 (Eu²⁺ + 2 free crowns)²⁺; 383.4 (free crown + Na⁺)⁺; 297.9 (M - 2 I⁻ + 2ACN)²⁺; 277.4 (M - 2 I⁻ + ACN)²⁺ | *The substance didn't sublimate, but decompose d at 300 °C* |
| M16 | **Europium(II) 6,9,12-trioxa-3,15-diaza-1(2,5)-furanacyclohexadecapha ne iodide** | 44 | 1.66E-6 mBar/ 230°C/ 90% | 562.2 (M - I⁻)⁺; 307.4 (free crown + Na⁺)⁺; 285.4 (free crown + H⁺)⁺; 250.9 (M - 2 I⁻ + 2MeOH)²⁺; 234.8 (M - 2 I⁻ + MeOH)²⁺ | Calc.: C, 24.37; H, 3.51; N, 4.06. |
| | | | | | Found.: C, 24.12; H, 3.62; N, 4.02 |

As evident from the elemental analyses, ESI-MS, and sublimation data summarized in Table 2, the complexes M7 and M12 each consist of a single Eu(II), a single macrocyclic ligand, and two anions, and can be sublimed and resublimed in near quantitative yields of ~94%. In contrast, CE1, which possesses a very similar to M7 general composition, but a much higher calculated dipole moment, cannot be sublimed. Furthermore, CE3 and CE4, which have even closer composition, being different from M7 only by the halogen anion size and nature, and also having the same low dipole moment, possess significantly reduced volatilities with the sublimation yields of 30% and 0%, respectively. This result shows the following: firstly, the dipole moment is not a single criterion, which defines the sublimation ability of a given compound, and an increase of the halogen anion size renders a positive effect on the volatility; secondly, the iodide anion enables near quantitative sublimation yields for coordination compounds, according to the present invention.

### Photo emission spectra

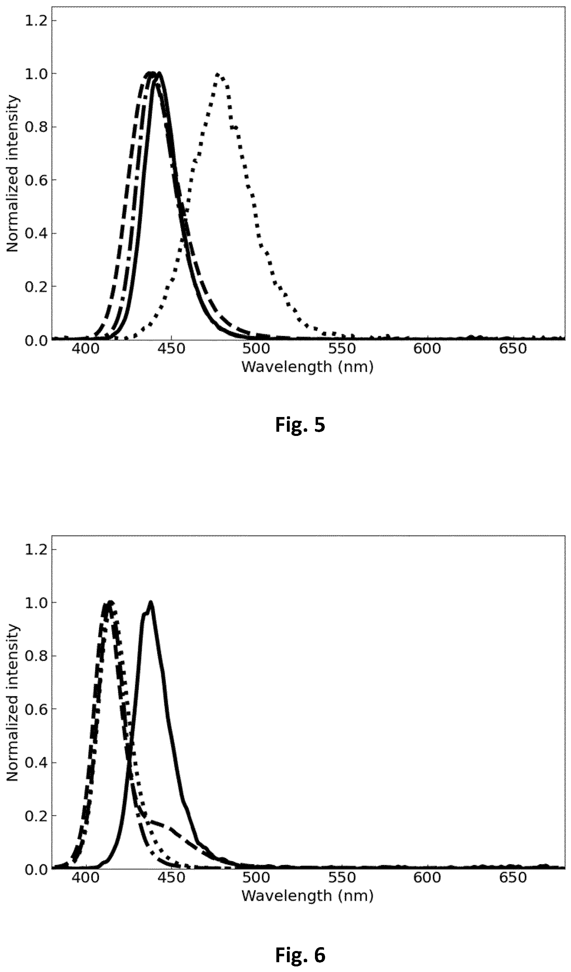

Photo-emission spectra of solid powders of M7 (solid line), CE1 (dotted line), CE2 (dash-dot line), and CE3 (dashed line), as solid powders are depicted in **Fig. 5****.** In all cases, the deep blue emission is observed, as summarized in **Table 2.** Similarly, photoemission spectra of solid powders of M16 (solid line), M1 (dash-dot line), M4 (dashed line), and M5 (dotted line) are provided in **Fig. 6****.** The experimentally observed emission data are very much inline with the calculated emission energies (EE) for the same coordination compounds depicted in **Table 3,** shown in the next paragraph.

**Table 2: Summary of the photo emission data for selected materials.**

| **Name** | **Anion** | **Peak of emission (eV)** | **Emission spectrum** |
|---|---|---|---|
| CE1 | tetraphenyl borate | 2.6 | FIG 5, dotted line |
| CE2 | bromide | 2.8 | FIG 5, dash-dot line |
| CE3 | chloride | 2.8 | FIG 5, dashed line |
| M1 | iodide | 3.0 | FIG 6, dash-dot line |
| M4 | iodide | 3.0 | FIG 6, dashed line |
| M5 | iodide | 3.0 | FIG 6, dotted line |
| M7 | iodide | 2.8 | FIG 5, solid line |
| M16 | iodide | 2.8 | FIG 6, solid line |

The samples for photo-emission spectra measurements were prepared in an inert atmosphere by placing 2 mg of the coordination compound powder in an air-tight sealed 10 mm x 10 mm quartz cuvette. The cuvette seals provide enough isolation from the ambient environment in which the measurement was carried out. The cuvettes were placed into a spectrofluorometer Edinburgh FS5. For all measurements, the excitation and emission slits of the measurement tool were set to 1 nm. A xenon lamp was used as the excitation source, with a software-controlled integrated monochromator set to 340 nm. The resulting emission spectra were recorded by scanning a window of 370 - 800 nm. The spectra displayed in Fig. 5 and Fig. 6 were normalized by dividing the measured count values by their respective maximal values to easily compare the spectral shapes.

### Details on how to calculate relevant parameters of Europium coordination compounds using quantum-chemical methods

The computational protocol to determine structures, emission energies (**EE**), and the excited-state electron binding energies of Eu(II) complexes in their electronic ground (4*f⁷*5*d ⁰*) (**EBE**) and first (energetically lowest) excited (4*f⁶*5*d*¹) (**ES-EBE**) state consists of 3 main steps, all of which can be accomplished with freely available open-source software (xTB: https:/github.com/grimme-lab/xtb; CREST https://github.com/crest-lab/crest; CENSO https://github.com/grimme-lab/CENSO) and the commercially available quantum-chemical program package ORCA (https://www.faccts.de/orca/). These three steps are firstly, the generation of a large comprehensive ensemble of all possible structures of given complex in a large energy window with fast semi-empirical methods, secondly a multi-level energetical screening, optimization, and reranking of the structures in the large ensemble with increasingly accurate density-functional theory (DFT) to determine the relevant (energetically lowest) conformer(s), and thirdly the calculation of the desired properties by combining time-dependent (TD)-DFT for the excited states with DFT for the ground states.

In principle, any quantum-chemistry software can be used for these calculations and would provide near-identical results if the methods described in detail below (functionals, dispersion corrections, basis sets, geometric Counter Poise corrections, effective core potentials, solvent models and parameters) are applied in the same way. Due to the statistical (non-deterministic) nature of the simulations in step one of this approach, the results are not exactly reproducible. However, if the simulation times are sufficiently long, the approach will always yield the same relevant (lowest energy) conformer after step 2, which will have very similar properties in the calculations in step 3. As a very conservative estimate, the precision of the predicted dipole moments (over repeated runs for the same molecule) should be ±1 D and ±0.1 eV for emission energies and ionization potentials.

In detail, the three main steps of the computation approach are:
1) **Generation of a comprehensive conformer ensemble** with the CREST program version 2.12 using the implemented semi-empirical tight-binding model GFN2-xTB in gas phase, as well as in combination with the Analytical Linearized Poission-Boltzmann (ALPB) solvation model with parameters for toluene as implemented in the xTB software version 6.4.1.
   This conformer generation step comprises at least two iterations with seven parallel metadynamics simulations, each with at least 30 picoseconds (ps) of simulation time (420 ps total simulation time). This step is done twice: Once with the ALPB solvation model with parameters for toluene solution, and once in gas phase, both starting from the input structure optimized at the same level of theory, yielding an overall simulation time of at least 840 ps (more can be necessary to generate a complete ensemble for particularly flexible complexes). The conformer ensembles from these two independent runs are then combined and sceened in the presence of the ALPB solvation model with parameters for hexane to obtain a final ranked ensemble that is passed on to the next step 2).
   Since CREST, by default, excludes all molecules with topological changes in the bonding pattern compared to the starting structure (as these are isomers not conformers), changes on the central Eu-atom have to be explicitly allowed by excluding Eu from the topology check (-notopo Eu). This is required to ensure that structures with different coordination geometries and numbers of ligand-atoms attached to Eu are also considered (e.g. an iodine coordinated to Eu(II) can move away and coordinate to an NH-proton instead). If isolated (not covalently bound) anions are included in the complex, like iodide or closocarborate, the NCI mode of CREST is invoked (-nci -wscal 1.3). All structures within 8 kcal/mol of the lowest structure are kept in the ensemble (and are thus included in step 2).
   Commandline prompt for the run in toluene with the input-structure input.xyz:
      *crest input.xyz -gfn2 -alpb toluene (-nci -wscal 1.3) -mdlen 30 -nmtd 7 -notopo Eu -ewin 8* Commandline prompt for the run in gas phase:
      *crest input.xyz -gfn2 (-nci -wscal 1.3) -mdlen 30 -nmtd 7 -notopo Eu -ewin 8*
      Commandline promt for the screening of the combined ensembles:
      *crest -screen combined.xyz -gfn2 -alpb hexane -notopo Eu -ewin 8*
2) **Multi-level screening, optimization, and reranking of the conformer ensemble** from 1. in 4 substeps with DFT methods of increasing accuracy using the CENSO program as driver and ORCA 5.0.3 to carry out the DFT calculations.
   **(A) Prescreening** based on PBE-D4/def2-SV(P)+gCP, single-point energies are calculted using the structures from step 1 (notation PBE-D4/def2-SV(P)+gCP// GFN2/ALPB(toluene)). Solvent effects are included by adding the GFN2-xTB/ALPB free energy of solvation (CENSO default) and the 28-electron def2-ECP effective core potential is used for Eu and all atoms heavier than krypton (ORCA default). All conformers whose energy is within 7 kcal/mol of the lowest conformer at this level of theory are included in step 2B.
      *Commandline prompt: censo -inp crest_conformers.xyz -solvent toluene -u 7 -chrg 0 -prog orca -part0 on -func0 pbe-d4 -part0_threshold 7*
   **(B) Screening** based on r2SCAN-3c, single-point energies are calculated for the structures from step 1 using the SMD model with parameters for toluene to include solvent effects (r²SCAN-3c/SMD(toluene)//GFN2-xTB/ALPB(toluene)). The resulting single-point energies are combined with thermostatistical contributions (zero-point vibrational energy, entropic and enthalpic vibrational, translational and rotational contributions) evaluated at the GFN2-xTB/ALPB(toluene) level of theory using the modified rigid-rotor harmonic-oscillator (mRRHO) approximation (CENSO default) to obtain free energies. All conformers with a free energy that is within 4.5 kcal/mol of the lowest conformer at this level of theory are included in step 2C.
      *Commandline prompt: censo -inp crest_conformers.xyz -solvent toluene -u 7 -chrg 0 -prog orca -part0 on -func0 pbe-d4 -part0_threshold 7 -part1 on -part1_threshold 4.5*
   **(C) Reoptimization** of the structures (from step 1) with r²SCAN-3c using the SMD solvent model with parameters for toluene and the "lax" convergence criteria setting of CENSO. Entropic and enthalpic contributions are included at the GFN2-xTB/ALPB(toluene) theory level using mRRHO approximation combined with the single-point Hessian approach (CENSO default). All conformers with a free energy that is within 1.5 kcal/mol of the lowest conformer at this level of theory are included in step 2D.
      *Commandline prompt: censo -inp crest_conformers.xyz -solvent toluene -u 7 -chrg 0 -prog orca -part0 on -func0 pbe-d4 -part0_threshold 7 -part1 on -part1_threshold 4.5 -part2 on - optlevel2 lax -part2_threshold 1.5*
   **(D) Final Reranking** of the structures from 2C using single-point energies calculated with the wB97X-V functional using the def2-TZVPP basis set and def2-ECPs and the SMD(toluene) model for solvent effects. Thermostatistical corrections (enthalpy, entropy) are taken from step 2C.
      If there is more than one structure within 1.0 kcal/mol of the lowest structure at this level of theory and the respective structures are similar, then only the lowest structure is taken to the next step (3). If there are two or more structures within 1 kcal/mol with different coordination geometries (different atoms coordinating to Eu, different coordination geometry), they are all included in the next step.
      *Command-line prompt: censo -inp crest_conformers.xyz -solvent toluene -u 7 -chrg 0 -prog orca -part0 on -func0 pbe-d4 -part1 on -part2 on -part3 on -func3 wb97xv -basis3 def2-tzvpp*
3) **Calculating of EE, EBE, and ES-EBE** from 2D with the wB97X-D3 dispersion-corrected density functional (ORCA keyword !wB97X-D3) using the def2-TZVP basis set and def2-ECPs 28-electron pseudopotential for Eu, the def2-SVP basis set (and if necessary def2-ECPs) for all other atoms, the geometrical Counter Poise correction (ORCA: gCP(DFT/SVP)) for basis set incompleteness error, and the SMD solvation model with (slightly modified, see below) parameters for anisole. Convergence thresholds for geometry optimizations in ORCA are set to "loose" (!LOOSEOPT).
   **EE: Emission energies** are calculated by optimizing the lowest electronically excited state of the lowest conformer from 2D with time-dependent (TD-)DFT/wB97X-D3 in the Tamm-Dancoff approximation (TDA) using the basis sets, corrections as specified in 3. For the excited-state optimization, the electronic part of the SMD solvation model (C-PCM) is replaced with the linear-response polarizable-continuum model (LR-PCM) using equilibrium solvation for the gradient calculation during the optimization, and non-equilibrium solvation for final emission energies (ORCA default). The emission energy corresponds to the energy of the first excited state after the optimization is converged.
   **EBE: Electron binding energies of the neutral coordination compound** are calculated as the difference between the electronic energy of the fully relaxed complex with ground-state Eu(II) and the energy of the fully relaxed complex with Eu(lll) (singly positively charged) according to the following equation: EBE = E(Eu2) - E(Eu3). The optimizations use the wB97X-D3 level of theory as specified in 3.
   **ES-EBE: Electron binding energy of Eu(II) in the lowest electronically excited state** is calculated as the electronic energy difference between the geometry-optimized complex with Eu(II) in its first excited state and the corresponding geometry-optimized complex with Eu(lll) (Eu3, singly positively charged) according to the following equation: ES-EBE = E(Eu2*) - E(Eu3). Optimization of the electronically excited Eu(II) complex uses the same TDA-wB97X-D3 level of theory as specified in 3B. Optimization of the Eu(III) complex uses the same ωB97X-D3 level of theory specified in 3 (sample inputs S2 and S3).

### Technical Details and Sample Inputs:

The workflow described in step 1. and 2. of this protocol is based on the one presented in the following article with some modifications to the default energy cutoffs and methods:
*Efficient Quantum Chemical Calculation of Structure Ensembles and Free Energies for Nonrigid Molecules*
S. Grimme, F. Bohle, A. Hansen, P. Pracht, S. Spicher, and M. Stahn
J. Phys. Chem. A 2021, 125, 19, 4039-4054 (https://pubs.acs.org/doi/pdf/10.1021/acs.jpca.1c00971)

All ORCA calculations for steps 2 and 3 employ the resolution-of-the-identity (RI) and chain-of-spheres-exchange (COSX) approximation with the implemented fitting basis sets (def2/J) and default integration grids.

The following sample jobs (S#) include all keywords relating to the methods described above. However, additional keywords and settings might be required in some or all cases to avoid technical problems (e.g. SCF convergence issues). As these settings depend on the individual case, they are not provided here.

### S1: Ground-State-Optimization of Eu(II) complex (Dipole Moment 3A and Ionization Potential 3C) !wB97X-D3 def2-SVP gCP(DFT/SVP) def2/J RIJCOSX LOOSEOPT

| | | |
|---|---|---|
| !CPCM | | |
| %cpcm | epsilon | 3 |
| | refrac | 2.25 |
| | SMD | true |
| | SMDsolvent | "ANISOLE" |
| end | | |
| %basis newgto Eu "def2-TZVP" end | | |
| end | | |
| *xyzfile 0 8 input.xyz | | |

### S2: Excited-State-Optimization of Eu(II) complex (Emission energy 3B and Ionization Potential 3D) !wB97X-D3 def2-SVP gCP(DFT/SVP) def2/J RIJCOSX LOOSEOPT

| | | |
|---|---|---|
| !CPCM | | |
| %cpcm | epsilon | 3 |
| | refrac | 2.25 |
| | SMD | true |
| | SMDsolvent | "ANISOLE" |
| end | | |
| %basis newgto Eu "def2-TZVP" end | | |
| end | | |
| %tddft | nroots | 4 |
| | iroot | 1 |
| | maxdim | 80 |
| | NGuessMat | 2048 |
| | maxiter | 250 |
| end | | |
| *xyzfile 0 8 input.xyz | | |

### S3: Ground-State-Optimization of Eu(III) complex (Ionization Potentials 3C and 3D) !wB97X-D3 def2-SVP gCP(DFT/SVP) def2/J RIJCOSX LOOSEOPT

| | | |
|---|---|---|
| !CPCM | | |
| %cpcm | epsilon | 3 |
| | refrac | 2.25 |
| | SMD | true |
| | SMDsolvent | "ANISOLE" |
| end | | |
| %basis newgto Eu "def2-TZVP" end | | |
| end | | |
| *xyzfile 1 7 input.xyz | | |

### Collection of calculated parameters of metal-organic coordination compounds according to the invention or various comparative examples

**Table 3: Summary of calculated parameters for various coordination compounds according to Fig. 2 and five comparative examples, obtained using the quantum chemical protocol described above.**

| **Emitter #** | *E*/*M* | **Dipole /D** | **EE /eV** | **EBE /eV** | **ES-EBE /eV** |
|---|---|---|---|---|---|
| CE1 | | 12.3 | 2.70 | 5.95 | 2.88 |
| CE2 | | 0.0 | 2.76 | 4.64 | 1.55 |
| CE3 | | 0.0 | 2.72 | 4.45 | 1.44 |
| CE4 | | 0.0 | 2.78 | 4.93 | 1.84 |
| CE5 | | 20.7 | 2.60 | 5.03 | 2.12 |
| M1 | | 0.0 | 3.06 | 5.37 | 2.15 |
| M2 | | 2.8 | 3.01 | 5.40 | 2.21 |
| M3 | | 1.7 | 2.83 | 5.22 | 2.11 |
| M5 | | 0.6 | 3.08 | 5.45 | 2.21 |
| M6 | | 0.0 | 2.71 | 5.51 | 2.56 |
| M7 | | 0.1 | 2.78 | 5.24 | 2.20 |
| M9 | | 3.3 | 2.79 | 5.21 | 2.19 |
| M10 | E4 | 1.7 | 2.68 | 5.36 | 2.44 |
| M15 | | 3.2 | 2.69 | 5.03 | 2.11 |
| M16 | | 3.2 | 2.91 | 5.35 | 2.26 |
| M18 | | 0.8 | 3.09 | 5.36 | 1.99 |
| M20 | | 1.5 | 3.03 | 5.60 | 2.40 |
| M24 | | 1.2 | 2.85 | 5.30 | 2.28 |
| M32 | | 1.0 | 3.11 | 5.55 | 2.10 |
| M33 | E5 | 3.2 | 2.89 | 5.56 | 2.52 |
| M35 | | 0.0 | 2.21 | 5.33 | 2.77 |
| M36 | E3 | 3.9 | 2.87 | 5.58 | 2.42 |
| M37 | E10 | 2.7 | 3.00 | 5.97 | 2.82 |
| M38 | E9 | 1.0 | 2.89 | 5.88 | 2.75 |
| M40 | E1 | 0.0 | 2.68 | 5.46 | 2.50 |
| M41 | E8 | 1.3 | 2.69 | 5.68 | 2.77 |
| M43 | E2 | 4.0 | 2.91 | 5.61 | 2.51 |
| M44 | E11 | 4.4 | 2.90 | 5.70 | 2.58 |
| M45 | | 4.6 | 2.82 | 5.33 | 2.31 |
| M46 | | 2.8 | 2.67 | 5.40 | 2.47 |
| M48 | E7 | 8.4 | 2.69 | 5.68 | 2.76 |
| M49 | | 2.0 | 2.84 | 5.47 | 2.42 |
| M50 | E6 | 1.8 | 2.90 | 5.75 | 2.70 |

Of the 51 emitters depicted in FIG. 2 as M1 to M51, 28 are thoroughly analyzed using quantum chemical calculations as described above. CE1 to CE5 denote comparative examples where tetraphenyl borate, bromide, or chloride have been used as anions instead of iodide, which is the only anion being present in coordination compounds according to the invention. CE1 to CE3 have is the same macrocyclic ligand diaza-18-crown-6 one as one exemplified in M7. CE4 corresponds to the complex with dithio-18-crown-6 ether in a combination with bromide counterions (the same ligand contains M6, in a combination with iodides). CE5 uses iodide, but here Eu(II) is coordination by tetra-aza-12-crown-4 ligands, which have been disclosed in CN113801148A(B) having 1:2 Eu:ligand stoichiometry.

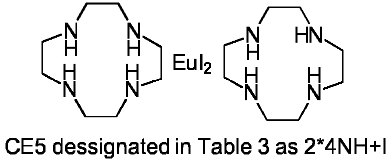

Further details on synthesis and chemical structure of the comparative examples CE1 to CE4 as well as of examples according to the invention can be found below.

Table 3 shows calculated dipole moment of all compounds given in Debye. A low dipole moment is one of prerequisites for a compound's high volatility and good solubility in non-polar solvents. All metal-organic coordination compounds according to the invention feature a dipole moment below 8.4 Debye, while most compounds exhibit values below 3.5 D, and many of them close to 0 D.

The next column shows the calculated emission energy (EE) in electron volts. The desirable color of the emission is deep blue spectral region corresponding to the emission energy of about 2.75 eV (2.90 eV> EE > 2.60 eV).

The column entitles EBE shows the electron-binding energy of the complex given in eV. The EBE of emitters should be above 5.5 eV to be sufficiently stable against oxidation of Eu(II) to Eu(III) by environmental oxygen, which enables handling of the metal-organic coordination compounds in ambient conditions.

Moreover, the EBE is directly linked to the excited-state EBE displayed in the next column, which describes how strong the emitter binds its electrons in the excited state relevant for emission. ES-EBE is related to the electron affinity (EA) and LUMO energies of common OLED materials. Accordingly, ES-EBE is a critical parameter for OLED function. Values above 2.2 eV are desirable, while values above 2.4 eV are preferred and values above 2.6 eV are most preferred. This is because higher values simplify the desired confinement of the charge carriers and allows for a much wider selection of host materials. Specifically, the (absolute) value of the LUMO of the host material is preferred to be below the ES-EBE value of the emitter, since otherwise electron-transfer might occur in the excited state.

A comparison of dipole moments for CE1 to CE3 with M7, all having the same diaza-18-crown-6 ligand but different anions, demonstrates a crucial effect of the anion. CE1 with the tetraphenyl borate anions has a dipole moment of 12.3 D, which renders the material non-volatile such that sublimation processing is not possible. Similarly, CE5, which assumes a sandwich-like geometry with two macrocycles smaller than those according to invention also has a high dipole moment of 20.7 D, rendering it much less volatile than the complexes according to invention. This low volatility precludes an application in OLEDs even though other parameters are acceptable.

Halogenides, such as, CE2 (bromide), CE3 (chloride), and M7 (iodide), all display very low dipole moments around zero D, which is a prerequisite for a high volatility of those compounds. However, our sublimation experiments demonstrate that sublimation yield decreases from iodide to bromide from 100% to 30%, respectively, whereas CE3 (chloride) completely decomposes upon sublimation. These results show that the dipole moment is not the only factor defining volatility. The difference in the volatility in those cases could be explained in terms of anion' ability to approach to the Eu(II) center and the thermodynamic stability of the respective EuX₂ salts, which increases with decreasing size of the halogen. The smallest in the series chloride anions penetrate from outer to inner sphere of the complex, which upon a heating in vacuum facilitates the formation of a stable inorganic ionic compound EuCl₂. Instead, the much larger iodide anion is well separated from Eu(II) and the respective salt is less stable, such that the formation of EuI₂ is not observed. The intermediate-sized bromide stays in between the extremes. This hypothesis is corroborated by the observed trends for other parameters in the CE2, CE3 and M7 series. For instance, CE2, CE3, and CE4 have significantly lower EBEs of 4.64 eV, 4.45 eV and 4.93 eV than M6 and M7 with 5.51 eV and 5.24 eV, respectively. This results from the smaller distance and thus stronger interactions of the lighter halogen with Eu(II) with the bromide compared to iodide anions, see Table 3.

Regarding EE, the vast majority of coordination compounds according to the present invention emit in the desirable deep blue spectral region, i.e., close to 2.75 eV. An exception is the series of all-oxo-crowns M2, M5, M18, M20, and M32, whose emission is in the ultraviolet rather than blue spectral regime. The use of those emitters in OLEDs is more challenging taking into account that matrices with an accordingly high triplet energy are scarce. A further exception is M35, where the use of phospor instead of nitrogen as donor atoms strongly red-shifts the emission into the yellow spectral region. A comparison of experimentally measured photoluminescence, given in Table 2, with calculation data for the same compounds, shown in Table 3, reveals an excellent correlation for the photoluminescence maxima (e.g., 2.76 vs 2.8 for CE2, 3.0 vs 3.06 for M1, 2.8 vs 2.78 for M7, 2.8 vs 2.91 for M16, for experiment vs calculations, respectively), which supports the validity of the calculation method.

Further, most of the emitters according to this invention have an EBE in the desirable range, i.e., above 5.5 eV, which provides satisfactory oxidation stability and enables the use of wide selection of hole injection and host materials. There is only one exception of a coordination compound, M15, with a low IP of 5.0 eV, provided by the presence of 5 NH donor groups.

Finally, the ES-EBE of the examples according to invention ranges from 1.99 eV to 2.82 eV. This is in contrast to some of the comparative examples, where in particular the bromide and chloride CE2 and CE3 have values as low as 1.55 eV and 1.44 eV, respectively. As previously discussed, values above 2.2 eV are preferred, while values above 2.4 eV are even more preferred to enable a wider selection of host materials in OLED applications. In this respect, the emitters M6, M10, M35, M40, M43, M44, M46, M48-50 with the chemically softer 3^{rd} and 4^{th} period donor atoms (sulfur, phosphor, selenium), as well as those with the strongly electron-withdrawing carborane bridges M37, M38, and M41 exhibit particularly desirable ES-EBE values.

A comparison of CE1 to CE4 with the examples according the invention, i.e., M6 and M7, illustrates how these key properties of the emitter change when different anions are used. As such, this comparison demonstrated the favourable impact of iodide compared to bromide and chloride. It is immediately clear that none of the comparative examples fulfils all three requirements to function in OLED device at the same time. CE2 (bromide) and CE3 (chloride) exhibit the desirable low dipole and deep-blue emission, but strong interactions of the corresponding anions with Eu(II) lead to EBE and ES-EBE values far below than the desired 5.0 eV and 2.2 eV, respectively. Thus, these are clearly not suitable for application in OLED due to issues with charge-carrier confinement and low ambient stability. In contrast, CE1 (BPh₄⁻) shows good emission color, EBE, and ES-EBE, however, due to its unfavourable asymmetric structure, it attains a large dipole moment of 12.3 D. As a result, the emitter using comparative anion CE1 is highly polar, not volatile, and thus not suitable for gas-transfer processing, as confirmed by the sublimation experiments.

Similarly, CE5 from the prior art CN113801148A(B) demonstrates that too small macrocycles which do not encompass the Eu(II) cation leads to a different ligand to Eu(II) ratio than the one according to invention, and, in turn, a much larger dipole moment and lower volatility. Hence, although CE5 exhibits blue luminescence with emission energy of 2.60 eV and a reasonable EBE values, it is insoluble in apolar solvents and does not sublime.

This is in contrast to many of the emitters according to invention, particularly M6, M33, M36, M38, M41, M43, M44, M49 and M50, all of which fulfil all four requirements: they have a small dipole moment, emission color in the deep blue region, an IP well above 5 eV, and an ES-EBE above 2.4 eV.

In conclusion, the combination of the iodide anions with the macrocyclic organic ligands according to the invention yields metal organic complexes with divalent Europium that are deep blue, can be processed using gas transfer processes, and have favorable electronic properties. The combination of deep blue color, high ambient stability, favorable electronic properties, and high volatility has indeed not been described in any prior art and as such describes a highly beneficial combination of properties, suitable to make deep blue and efficient OLED devices.

### Device examples according to the present invention

A representative embodiment of an organic electronic device according to various embodiments will now be described, including a detailed description of the fabrication process of the organic electronic device. Yet, it will be understood that neither the specific techniques for fabrication of the device, nor the specific device layout, nor the specific compounds are intended to limit the scope of the present invention.

### Material definitions:

- ITO:: Indium tin oxide, transparent anode
- NPB:: N,N'-Bis(naphthalen-1-yl)-N,N'-bis(phenyl)benzidine
- TAPC:: 1,1-Bis[(di-4-tolylamino)phenyl]cyclohexane
- HT1:: 3-[Cyano(4-cyano-2,3,5,6-tetrafluorophenyl)methylene]-α1,α2-bis(4-cyano-2,3,5,6-tetrafluorophenyl)-1-cyclopropene-1,2-diacetonitrile
- HB1:: [3-(4,6-diphenyl-1,3,5-triazin-2-yl)phenyl]tris(phenyl)silane
- ET1:: 11-phenyl-11H-benzo[b]dinaphtho[2,1-d:1',2'-f]phosphepine 11-oxide
- Yb:: Ytterbium
- Al:: Aluminium
The organic electronic devices were prepared with the following layer sequencees:
Device 1
ITO / NPB:HT1 7:3 nm / NPB 40 nm / TAPC 10 nm / TAPC: **M7** 18:2 nm / HB1 10 nm / ET1:Yb 36:4 nm / Al 120 nm.

The organic electronic device was fabricated on a 1"x1" size glass substrate, pre-coated with a transparent ITO anode and a pixel definition layer. The substrates were ordered from Geomatec and used as received. The substrates were loaded into an ultra-high vacuum evaporation tool operating at around 10⁻⁷ mbar pressure. Here, the organic layers were deposited onto the substrate in the sequence stated above. In the case of TAPC:HT1, TAPC:**M7**, ET1:Yb, a co-evaporation process was used with both materials evaporating at the same time at different rates, corresponding to the resulting mixed layers, with quoted partial layer thickness. The device was finished by evaporating a 120 nm film of cathode Al. The Al deposition was carried out using a structured shadow mask, such that the resulting overlap of pre-structured ITO, organic layers and Al gave an active area of 3.88 mm². Subsequently, the devices were transferred to a nitrogen atmosphere glovebox and encapsulated by gluing an additional encapsulating glass substrate on top to prevent oxygen- and water-induced degradation. A moisture-absorbing liquid getter is dispensed onto the encapsulating glass substrate before the encapsulating glass is glued. The electrical and electroluminescent properties of the device were measured using an integrated OLED characterization setup M7000 (McScience inc.).

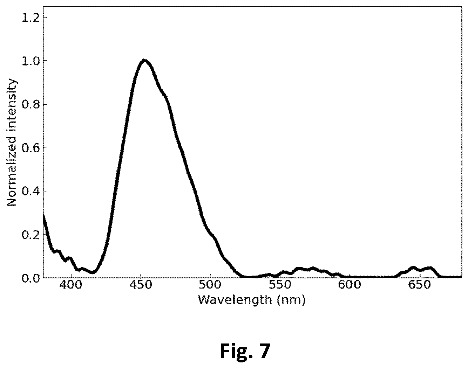

The device showed maximal EQE of up to 17 %EQE and emitted light with deep blue emission spectrum peaking at 2.75 eV. The resulting EL spectrum is presented in **Fig. 7****.** Evidently, the electroluminescence spectrum of the device resembles the photoluminescence spectrum of the coordination compound **M7** very well and the device emits in deep blue spectral region, and therefore is suitable for flat panel display applications.

## Claims

1. A metal-organic coordination compound, formed of a divalent Europium cation, a macrocyclic organic ligand, and iodide anions in an amount to make the coordination compound electrically neutral, with the macrocyclic organic ligand comprising 16 to 23, preferably 18 to 20 ring atoms in a single macrocycle ring accommodating the divalent Europium, with the exception of macrocyclic organic ligands M1 to M5: 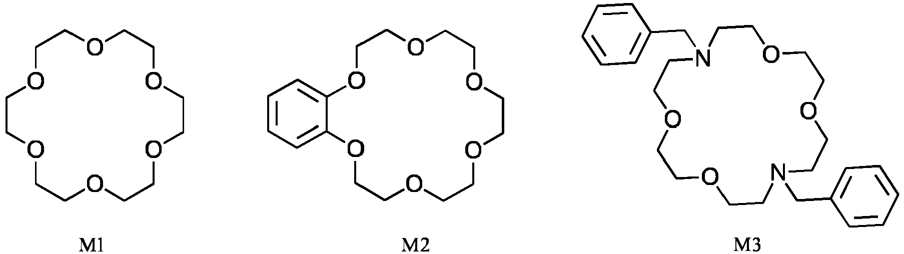 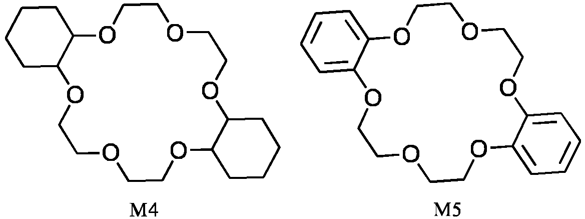 wherein the macrocyclic organic ligand has the formula (1-1): 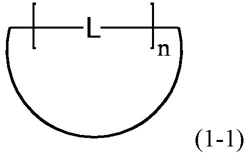 with
• **n** being 4 to 6; more preferable 6 and
• **L** being independently in each occurrence a divalent organic group formed by removing two hydrogen atoms from an organic molecule containing at least two hydrogen atoms, with
∘ the shortest sequence of atoms in each **L** between the two linkages of each **L** with the remainder of the macrocycle in the macrocyclic ligand being 2 to 4, preferably 3 or 4 atoms, and with
∘ one of those 2 to 4, preferably 3 or 4 atoms independently for each **L** being selected from the heteroatoms B, N, P, S, Se, Si or O, preferably N, S, Se or O, the other atoms in the shortest sequence of atoms being carbon,
wherein preferably the heteroatoms in the macrocycle are non-neighboring, and wherein any further ring structures, forming part of the macrocyclic organic ligand in addition to the macrocycle itself are covalently linked with one macrocycle atom, or form part of the macrocycle by 1,2-, 1,3- or 1,4-annelation of the further ring structure to the macrocycle, and are not additionally covalently linked with other atoms of the macrocycle.

2. The metal-organic coordination compound according to claim 1, wherein **L** independently in each occurrence is selected from (2-1) to (2-5): 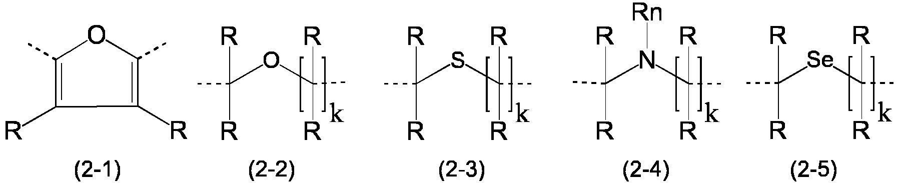 wherein
• **R** and **Rₙ** are H, D, or a covalently bound substituent being identical or different in each occurrence, and
• **k** is independently in each occurrence 1 or 2
• two to four instances of **R** present on neighboring carbon atoms independently in each occurrence may fuse, and
• the dashed lines indicate the covalent linkage to the remainder of the macrocyclic ligand according to formula (1-1).

3. The metal-organic coordination compound according to any of claims 1 or 2, wherein the macrocyclic organic ligand is selected from the generic formulae (3-1) to (3-3): 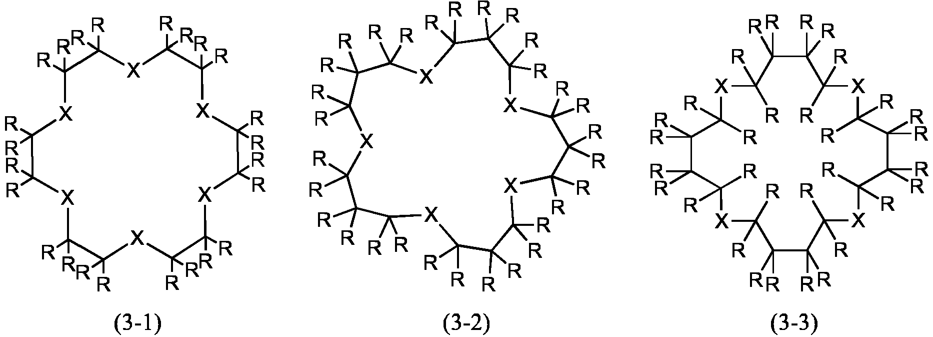 with
• **X** independently in each occurrence being N-**Rₙ**, S, Se, or O, and
• **R** and **Rₙ** being identical or different in each occurrence and being H, D, or any covalently linked monovalent organic group formed by removing a hydrogen atom from an organic molecule containing at least one hydrogen atom, wherein
• two, three, or four instances of **R** being present on the same or neighboring carbon atoms can be fused.

4. The metal-organic coordination compound according to one of claims 1 to 3, wherein the macrocyclic organic ligand is selected from E1 to E12:

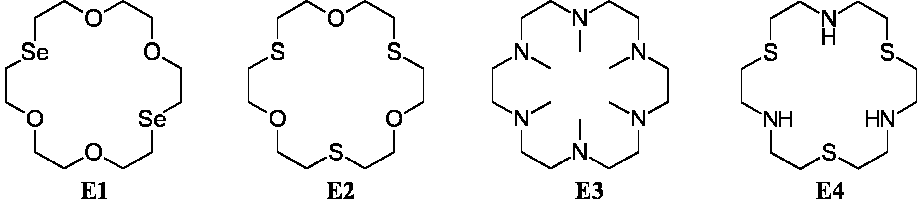

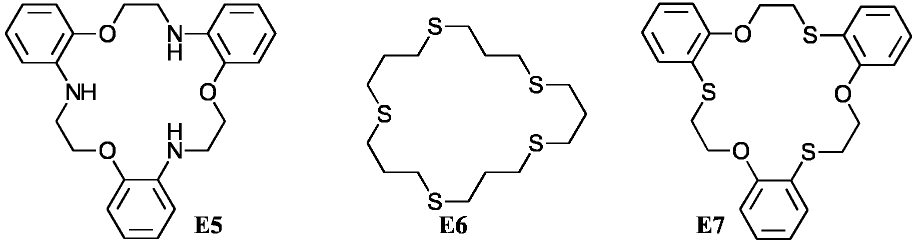

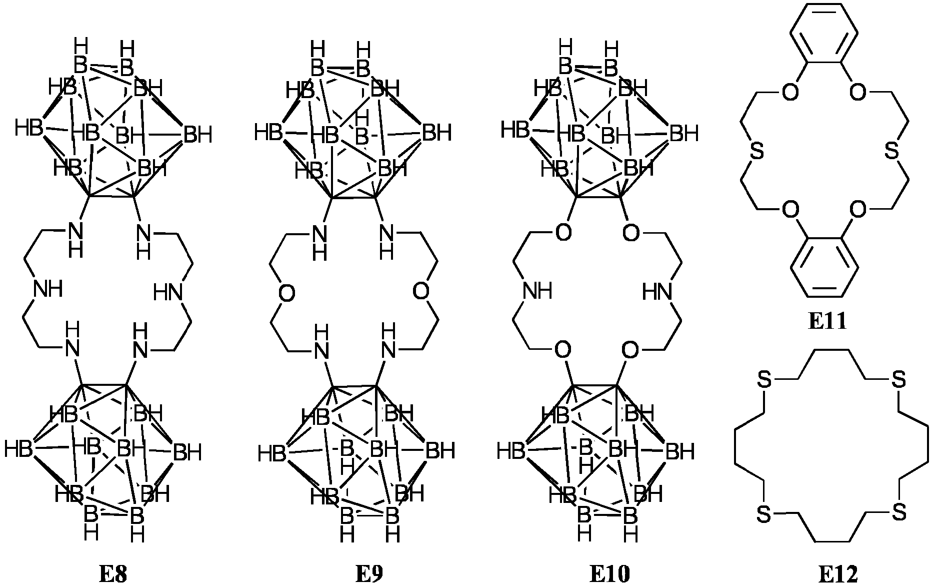

5. The metal-organic coordination compound, according to one of claims 1 to 4, wherein the coordination compound consists of a divalent Europium cation and iodide anions and a macrocyclic organic ligand, with Europium, macrocyclic ligand iodide anions being at 1:1:2 molar ratio.

6. A layer comprising
(a) at least one metal-organic coordination compound, formed of a divalent Europium cation, a macrocyclic organic ligand, and iodide anions in an amount to make the coordination compound electrically neutral, with the macrocyclic organic ligand comprising 16 to 23, preferably 18 to 20 ring atoms in a single macrocycle ring accommodating the divalent Europium, wherein the macrocyclic organic ligand has the formula (1-1): 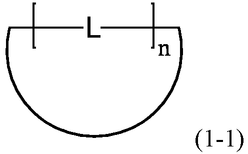 with
• **n** being 4 to 6; more preferable 6 and
• **L** being independently in each occurrence a divalent organic group formed by removing two hydrogen atoms from an organic molecule containing at least two hydrogen atoms, with
∘ the shortest sequence of atoms in each **L** between the two linkages of each **L** with the remainder of the macrocycle in the macrocyclic ligand being 2 to 4, preferably 3 or 4 atoms, and with
∘ one of those 2 to 4, preferably 3 or 4 atoms independently for each **L** being selected from the heteroatoms B, N, P, S, Se, Si or O, preferably N, S, Se or O, the other atoms in the shortest sequence of atoms being carbon,
wherein preferably the heteroatoms in the macrocycle are non-neighboring, and wherein any further ring structures, forming part of the macrocyclic organic ligand in addition to the macrocycle itself are covalently linked with one macrocycle atom, or form part of the macrocycle by 1,2-, 1,3- or 1,4-annelation of the further ring structure to the macrocycle, and are not additionally covalently linked with other atoms of the macrocycle,
and
(b) at least one second electrically neutral organic compound different therefrom, wherein the at least one metal-organic coordination compound (a) is imbedded into the at least one second electrically neutral organic compound (b),
the layer preferably having one or more of the following features:
- the second compound (b) is a charge-neutral host material;
- the second organic compound (b) has a triplet energy higher than 2.5 eV, preferably higher than 2.6 eV and more preferably higher than 2.7 eV;
- compounds (a) and (b) are physically mixed or the second charge-neutral compound (b) has a molecular weight Mₙ above 1000 g/mol and the coordination compound (a) and the second charge-neutral compound (b) are chemically linked with each other, for example by a covalent or coordinative chemical bond;
- the coordination compound (a) is imbedded into the at least one second electrically neutral organic compound (b) in a ratio of 0.1 to 99 vol%, based on the mixture which is 100 vol%;
- the second organic compound (b) has a lower hole affinity compared to the electrically neutral coordination compound (a);
- the second organic compound (b) has a lower electron affinity compared to the singly positively charged coordination compound (a);
- the second material is a charge transport organic material capable of transporting positive or negative charges.

7. The layer according to claim 6, wherein the at least one metal-organic coordination compound (a) is selected from metal-organic coordination compounds as defined in one of claims 1 to 5.

8. An organic electronic device, comprising:
a first electrode;
a second electrode; and
an organic layer arranged such that it is electrically interposed between the first and
second electrodes, wherein the organic layer comprises at least one metal-organic coordination compound, formed of a divalent Europium cation, a macrocyclic organic ligand, and iodide anions in an amount to make the coordination compound electrically neutral, with the macrocyclic organic ligand comprising 16 to 23, preferably 18 to 20 ring atoms in a single macrocycle ring accommodating the divalent Europium, wherein the macrocyclic organic ligand has the formula (1-1): 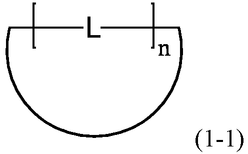 with
• **n** being 4 to 6; more preferable 6 and
• **L** being independently in each occurrence a divalent organic group formed by removing two hydrogen atoms from an organic molecule containing at least two hydrogen atoms, with
∘ the shortest sequence of atoms in each **L** between the two linkages of each **L** with the remainder of the macrocycle in the macrocyclic ligand being 2 to 4, preferably 3 or 4 atoms, and with
∘ one of those 2 to 4, preferably 3 or 4 atoms independently for each L being selected from the heteroatoms B, N, P, S, Se, Si or O, preferably N, S, Se or O, the other atoms in the shortest sequence of atoms being carbon,
wherein preferably the heteroatoms in the macrocycle are non-neighboring, and wherein any further ring structures, forming part of the macrocyclic organic ligand in addition to the macrocycle itself are covalently linked with one macrocycle atom, or form part of the macrocycle by 1,2-, 1,3- or 1,4-annelation of the further ring structure to the macrocycle, and are not additionally covalently linked with other atoms of the macrocycle,
or the organic layer is as defined in claim 6 or 7, wherein preferably the organic electronic device is an optoelectronic device, the optoelectronic device preferably being at least one of an organic light emitting diode, an organic photodetector, or a photovoltaic cell.

9. The organic electronic device according to claim 8, wherein the at least one metal-organic coordination compound (a) is selected from metal-organic coordination compounds as defined in one of claims 1 to 5.

10. A method of forming a layer according to claim 6 or 7 or an organic electronic device according to claim 8 or 9, the method comprising:
forming a layer of the metal-organic coordination compound (a) as defined in claim 6 or 7, or forming the layer as defined in claim 8 or 9,
wherein the layer is deposited from a gas phase, in particular using an evaporation and/or sublimation and/or carrier gas process, or wherein the layer is deposited from solution, whereby preferably the solution is comprised substantially of organic solvents with a polarity index of less than 5.0, preferably of less than 4.0, more preferably of less than 3.0.

11. The use of a metal-organic coordination compound according to any one of claims 1 to 5 or of a layer according to claim 6 or 7 as passive or active light emitting material in electroluminescent electronics applications or as a dye or contrast enhancement medium for magnetic resonance tomography.

## Patentansprüche

1. Metallorganische Koordinationsverbindung, gebildet aus einem zweiwertigen Europiumkation, einem makrocyclischen organischen Liganden und Iodidanionen in einer Menge, die die Koordinationsverbindung elektrisch neutral macht, wobei der makrocyclische organische Ligand 16 bis 23, vorzugsweise 18 bis 20, Ringatome in einem einzigen Makrocyclusring umfasst, der das zweiwertige Europium beherbergt, mit Ausnahme der makrocyclischen organischen Liganden M1 bis M5: 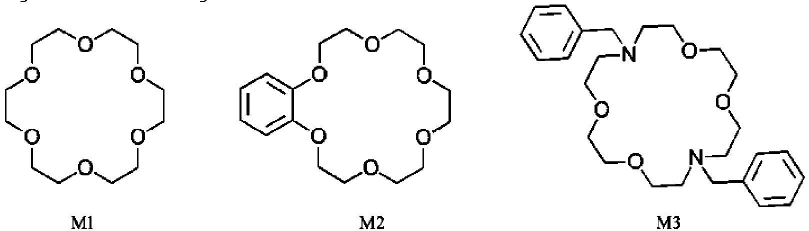 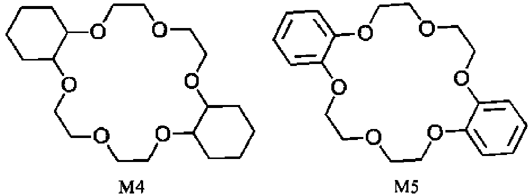 wobei der makrocyclische organische Ligand die Formel (1-1) aufweist: 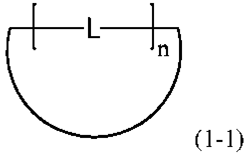 wobei
• n = 4 bis 6; weiter bevorzugt 6, ist und
• L unabhängig bei jedem Auftreten für eine zweiwertige organische Gruppe, die durch Entfernen von zwei Wasserstoffatomen von einem organischen Molekül, das mindestens zwei Wasserstoffatome enthält, gebildet wird, steht, wobei
∘ die kürzeste Abfolge von Atomen in jedem L zwischen den beiden Verknüpfungen jedes L mit dem Rest des Makrocyclus in dem makrocyclischen Liganden 2 bis 4, vorzugsweise 3 oder 4, Atome, beträgt und wobei
∘ eines dieser 2 bis 4, vorzugsweise 3 oder 4, Atome unabhängig für jedes L aus den Heteroatomen B, N, P, S, Se, Si oder O, vorzugsweise N, S, Se oder O, ausgewählt ist, wobei es sich bei den anderen Atomen in der kürzesten Abfolge von Atomen um Kohlenstoff handelt,
wobei vorzugsweise die Heteroatome im Makrocyclus nicht benachbart sind, und wobei beliebige weitere Ringstrukturen, die zusätzlich zu dem Makrocyclus selbst einen Teil des makrocyclischen organischen Liganden bilden, kovalent mit einem Makrocyclusatom verknüpft sind oder durch 1,2-, 1,3- oder 1,4-Anellierung der weiteren Ringstruktur an den Makrocyclus einen Teil des Makrocyclus bilden und nicht zusätzlich kovalent mit anderen Atomen des Makrocyclus verknüpft sind.

2. Metallorganische Koordinationsverbindung nach Anspruch 1, wobei L unabhängig bei jedem Auftreten aus (2-1) bis (2-5) ausgewählt ist: 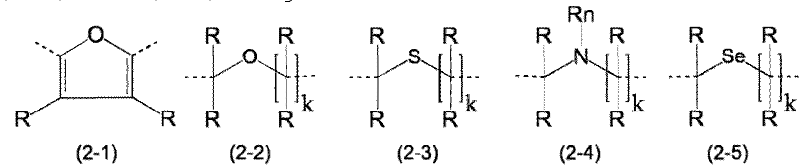 wobei
• R und Rₙ für H, D oder einen kovalent gebundenen Substituenten, der bei jedem Auftreten gleich oder verschieden ist, stehen und
• K bei jedem auftreten unabhängig für 1 oder 2 steht,
• zwei bis vier Vorkommen von R, die an benachbarten Kohlenstoffatomen vorliegen, unabhängig bei jedem Auftreten kondensiert sein können, und
• die gestrichelten Linien die kovalente Verknüpfung mit dem Rest des makrocyclischen Liganden gemäß Formel (1-1) anzeigen.

3. Metallorganische Koordinationsverbindung nach Anspruch 1 oder 2, wobei der makrocyclische organische Ligand aus den generischen Formeln (3-1) bis (3-3) ausgewählt ist: 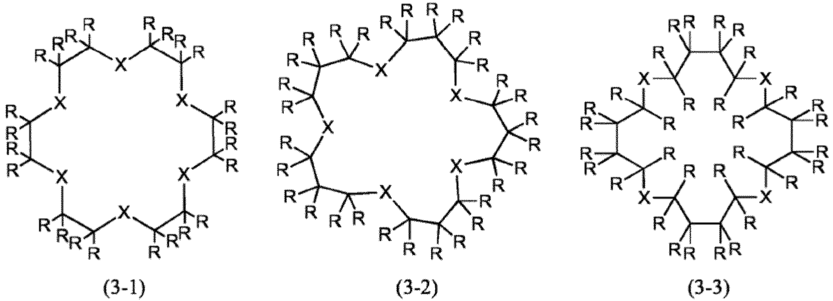 wobei
• X unabhängig bei jedem Auftreten für N-Rₙ, S, Se oder O steht und
• R und Rₙ bei jedem Auftreten gleich oder verschieden sind und für H, D oder eine kovalent verknüpfte einwertige organische Gruppe, die durch Entfernen eines Wasserstoffatoms von einem organischen Molekül, das mindestens ein Wasserstoffatom enthält, gebildet wird, stehen, wobei
• zwei, drei oder vier Vorkommen von R, die an demselben Kohlenstoffatom oder benachbarten Kohlenstoffatomen vorliegen, kondensiert sein können.

4. Metallorganische Koordinationsverbindung nach einem der Ansprüche 1 bis 3, wobei der makrocyclische organische Ligand aus E1 bis E12 ausgewählt ist:

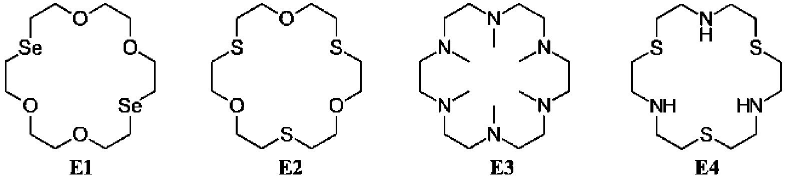

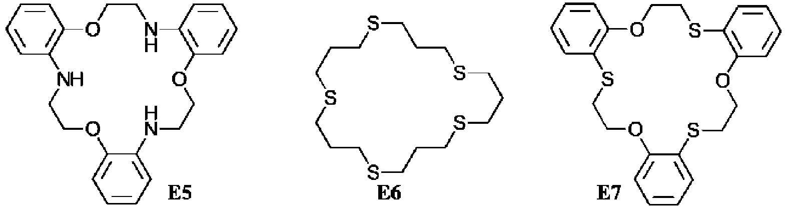

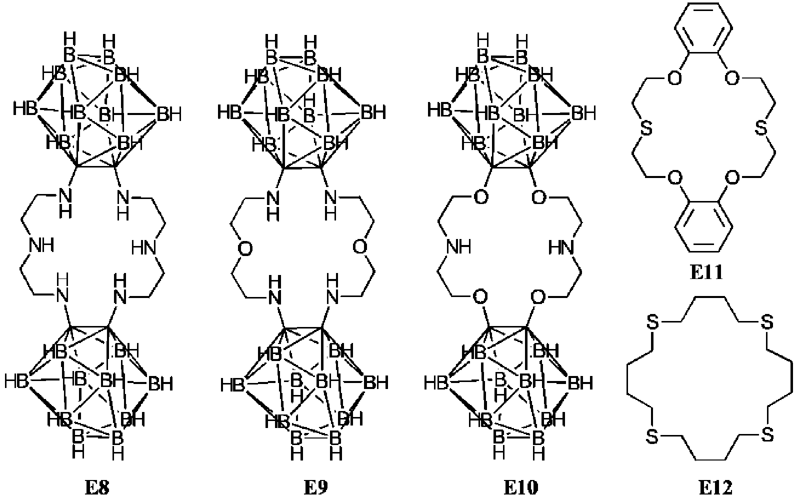

5. Metallorganische Koordinationsverbindung nach einem der Ansprüche 1 bis 4, wobei die Koordinationsverbindung aus einem zweiwertigen Europiumkation und Iodidanionen und einem makrocyclischen organischen Liganden besteht, wobei Europium, makrocyclischer Ligand und Iodidanionen im Molverhältnis 1:1:2 vorliegen.

6. Schicht, umfassend
(a) mindestens eine metallorganische Koordinationsverbindung, gebildet aus einem zweiwertigen Europiumkation, einem makrocyclischen organischen Liganden und Iodidanionen in einer Menge, die die Koordinationsverbindung elektrisch neutral macht, wobei der makrocyclische organische Ligand 16 bis 23, vorzugsweise 18 bis 20, Ringatome in einem einzigen Makrocyclusring umfasst, der das zweiwertige Europium beherbergt, wobei der makrocyclische organische Ligand die Formel (1-1) aufweist: 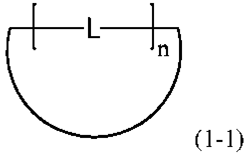 wobei
• n = 4 bis 6; weiter bevorzugt 6, ist und
• L unabhängig bei jedem Auftreten für eine zweiwertige organische Gruppe, die durch Entfernen von zwei Wasserstoffatomen von einem organischen Molekül, das mindestens zwei Wasserstoffatome enthält, gebildet wird, steht, wobei
∘ die kürzeste Abfolge von Atomen in jedem L zwischen den beiden Verknüpfungen jedes L mit dem Rest des Makrocyclus in dem makrocyclischen Liganden 2 bis 4, vorzugsweise 3 oder 4, Atome, beträgt und wobei
∘ eines dieser 2 bis 4, vorzugsweise 3 oder 4, Atome unabhängig für jedes L aus den Heteroatomen B, N, P, S, Se, Si oder O, vorzugsweise N, S, Se oder O, ausgewählt ist, wobei es sich bei den anderen Atomen in der kürzesten Abfolge von Atomen um Kohlenstoff handelt,
wobei vorzugsweise die Heteroatome im Makrocyclus nicht benachbart sind, und wobei beliebige weitere Ringstrukturen, die zusätzlich zu dem Makrocyclus selbst einen Teil des makrocyclischen organischen Liganden bilden, kovalent mit einem Makrocyclusatom verknüpft sind oder durch 1,2-, 1,3- oder 1,4-Anellierung der weiteren Ringstruktur an den Makrocyclus einen Teil des Makrocyclus bilden und nicht zusätzlich kovalent mit anderen Atomen des Makrocyclus verknüpft sind,
und
(b) mindestens eine davon verschiedene zweite elektrisch neutrale organische Verbindung, wobei die mindestens eine metallorganische Koordinationsverbindung (a) in die mindestens eine zweite elektrisch neutrale organische Verbindung (b) eingebettet ist,
wobei die Schicht vorzugsweise eines oder mehrere der folgenden Merkmale aufweist:
- die zweite Verbindung (b) ist ein ladungsneutrales Wirtsmaterial;
- die zweite organische Verbindung (b) weist eine Triplettenergie von mehr als 2,5 eV,
vorzugsweise mehr als 2,6 eV und weiter bevorzugt mehr als 2,7 eV auf;
- die Verbindungen (a) und (b) sind physikalisch gemischt oder die zweite ladungsneutrale Verbindung (b) weist ein Molekulargewicht Mₙ über 1000 g/mol auf und die Koordinationsverbindung (a) und die zweite ladungsneutrale Verbindung (b) sind chemisch miteinander verknüpft, zum Beispiel über eine kovalente oder koordinative chemische Bindung;
- die Koordinationsverbindung (a) ist in einem Anteil von 0,1 bis 99 Vol.-%, bezogen auf die Mischung, die 100 Vol.-% beträgt, in die mindestens eine zweite elektrisch neutrale organische Verbindung (b) eingebettet;
- die zweite organische Verbindung (b) weist eine geringere Lochaffinität als die elektrisch neutrale Koordinationsverbindung (a) auf;
- die zweite organische Verbindung (b) weist eine geringere Elektronenaffinität als die einfach positiv geladene Koordinationsverbindung (a) auf;
- das zweite Material ist ein organisches Ladungstransportmaterial, das positive oder negative Ladungen transportieren kann.

7. Schicht nach Anspruch 6, wobei die mindestens eine metallorganische Koordinationsverbindung (A) aus metallorganischen Koordinationsverbindungen gemäß einem der Ansprüche 1 bis 5 ausgewählt ist.

8. Organische elektronische Vorrichtung, umfassend:
eine erste Elektrode;
eine zweite Elektrode und
eine organische Schicht, die so angeordnet ist, dass sie sich elektrisch zwischen der ersten und der zweiten Elektrode befindet, wobei die organische Schicht mindestens eine metallorganische Koordinationsverbindung, gebildet aus einem zweiwertigen Europiumkation, einem makrocyclischen organischen Liganden und Iodidanionen in einer Menge, die die Koordinationsverbindung elektrisch neutral macht, umfasst, wobei der makrocyclische organische Ligand 16 bis 23, vorzugsweise 18 bis 20, Ringatome in einem einzigen Makrocyclusring umfasst, der das zweiwertige Europium beherbergt, wobei der makrocyclische organische Ligand die Formel (1-1) aufweist: 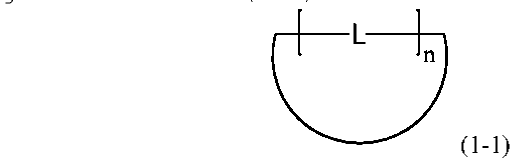 wobei
• n = 4 bis 6; weiter bevorzugt 6, ist und
• L unabhängig bei jedem Auftreten für eine zweiwertige organische Gruppe, die durch Entfernen von zwei Wasserstoffatomen von einem organischen Molekül, das mindestens zwei Wasserstoffatome enthält, gebildet wird, steht, wobei
∘ die kürzeste Abfolge von Atomen in jedem L zwischen den beiden Verknüpfungen jedes L mit dem Rest des Makrocyclus in dem makrocyclischen Liganden 2 bis 4, vorzugsweise 3 oder 4, Atome, beträgt und wobei
∘ eines dieser 2 bis 4, vorzugsweise 3 oder 4, Atome unabhängig für jedes L aus den Heteroatomen B, N, P, S, Se, Si oder O, vorzugsweise N, S, Se oder **O,** ausgewählt ist, wobei es sich bei den anderen Atomen in der kürzesten Abfolge von Atomen um Kohlenstoff handelt,
wobei vorzugsweise die Heteroatome im Makrocyclus nicht benachbart sind, und wobei beliebige weitere Ringstrukturen, die zusätzlich zu dem Makrocyclus selbst einen Teil des makrocyclischen organischen Liganden bilden, kovalent mit einem Makrocyclusatom verknüpft sind oder durch 1,2-, 1,3- oder 1,4-Anellierung der weiteren Ringstruktur an den Makrocyclus einen Teil des Makrocyclus bilden und nicht zusätzlich kovalent mit anderen Atomen des Makrocyclus verknüpft sind,
oder die organische Schicht wie in Anspruch 6 oder 7 definiert ist, wobei vorzugsweise die organische elektronische Vorrichtung eine optoelektronische Vorrichtung ist, wobei es sich bei der optoelektronischen Vorrichtung vorzugsweise um eine organische Leuchtdiode, einen organischen Photodetektor oder eine Photovoltaikzelle handelt.

9. Organische elektronische Vorrichtung nach Anspruch 8, wobei die mindestens eine metallorganische Koordinationsverbindung (A) aus metallorganischen Koordinationsverbindungen gemäß einem der Ansprüche 1 bis 5 ausgewählt ist.

10. Verfahren zur Bildung einer Schicht nach Anspruch 6 oder 7 oder einer organischen elektronischen Vorrichtung nach Anspruch 8 oder 9, wobei das Verfahren Folgendes umfasst:
Bilden einer Schicht aus der metallorganischen Koordinationsverbindung (a) gemäß Anspruch 6 oder 7 oder Bilden der Schicht gemäß Anspruch 8 oder 9,
wobei die Schicht aus einer Gasphase, insbesondere unter Verwendung eines Verdampfungs- und/oder Sublimations- und/oder Trägergasverfahrens, abgeschieden wird oder wobei die Schicht aus Lösung abgeschieden wird, wobei die Lösung vorzugsweise weitgehend aus organischen Lösungsmitteln mit einem Polaritätsindex von weniger als 5,0, vorzugsweise von weniger als 4,0, weiter bevorzugt von weniger als 3,0, besteht.

11. Verwendung einer metallorganischen Koordinationsverbindung nach einem der Ansprüche 1 bis 5 oder einer Schicht nach Anspruch 6 oder 7 als passives oder aktives lichtemittierendes Material in Elektrolumineszenz-Elektronikanwendungen oder als Farbstoff oder Kontrastverstärkungsmedium für die Magnetresonanztomographie.

## Revendications

1. Composé de coordination organométallique, formé d'un cation europium divalent, d'un ligand organique macrocyclique et d'anions iodure en une quantité permettant de rendre le composé de coordination électriquement neutre, le ligand organique macrocyclique comprenant 16 à 23, de préférence 18 à 20 atomes de cycle dans un seul cycle macrocyclique accueillant l'europium divalent, à l'exception des ligands organiques macrocycliques M1 à M5 : 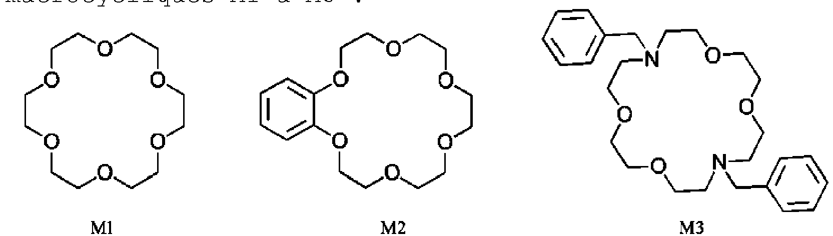 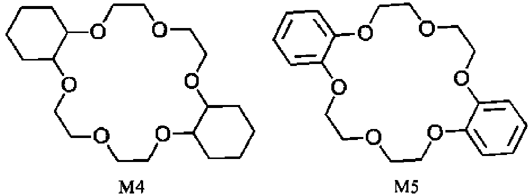 dans lequel le ligand organique macrocyclique répond à la formule (1-1) : 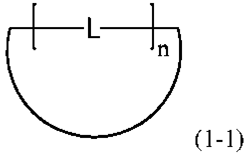
• n valant 4 à 6 ; plus préférablement 6 et
• L étant indépendamment à chaque occurrence un groupe organique divalent formé par élimination de deux atomes d'hydrogène d'une molécule organique contenant au moins deux atomes d'hydrogène,
∘ la séquence d'atomes la plus courte dans chaque L entre les deux liaisons de chaque L avec le reste du macrocycle dans le ligand macrocyclique étant de 2 à 4, de préférence 3 ou 4 atomes, et
∘ l'un de ces 2 à 4, de préférence 3 ou 4 atomes indépendamment pour chaque L étant choisi parmi les hétéroatomes B, N, P, S, Se, Si ou O, de préférence N, S, Se ou O, les autres atomes se trouvant dans la séquence d'atomes la plus courte étant le carbone,
dans lequel de préférence les hétéroatomes se trouvant dans le macrocycle ne sont pas voisins et dans lequel toutes les structures cycliques supplémentaires, faisant partie du ligand organique macrocyclique en plus du macrocycle lui-même, sont liées de façon covalente à un atome du macrocycle ou font partie du macrocycle par annélation 1,2-, 1,3- ou 1,4- de la structure cyclique supplémentaire au macrocycle et ne sont pas de plus liées de façon covalente à d'autres atomes du macrocycle.

2. Composé de coordination organométallique selon la revendication 1, dans lequel L indépendamment à chaque occurrence est choisi parmi (2-1) à (2-5) : 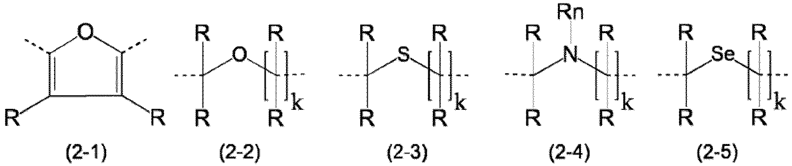 dans lequel
• R et Rₙ sont H, D ou un substituant lié de façon covalente qui est identique ou différent à chaque occurrence et
• k vaut indépendamment à chaque occurrence 1 ou 2
• deux à quatre cas de R présents sur des atomes de carbone voisins peuvent indépendamment à chaque occurrence fusionner et
• les lignes pointillées indiquent la liaison covalente avec le reste du ligand macrocyclique selon la formule (1-1).

3. Composé de coordination organométallique selon l'une quelconque des revendications 1 ou 2, dans lequel le ligand organique macrocyclique est choisi parmi les formules génériques (3-1) à (3-3) : 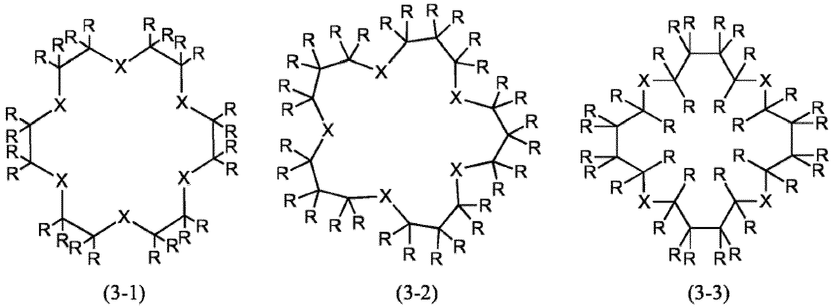
• X étant indépendamment à chaque occurrence N-Rₙ, S, Se ou O et
• R et Rₙ étant identiques ou différents à chaque occurrence et étant H, D ou un quelconque groupe organique monovalent lié de façon covalente formé par élimination d'un atome d'hydrogène d'une molécule organique contenant au moins un atome d'hydrogène, dans lequel
• deux, trois ou quatre cas de R qui sont présents sur le même atome de carbone ou sur des atomes de carbone voisins peuvent être fusionnés.

4. Composé de coordination organométallique selon l'une des revendications 1 à 3, dans lequel le ligand organique macrocyclique est choisi parmi E1 à E12 :

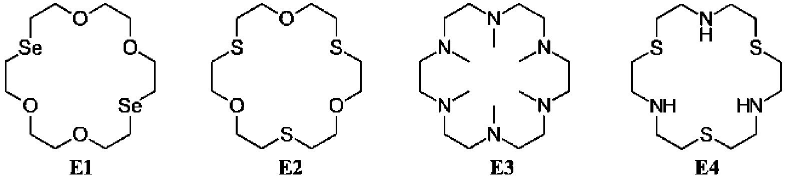

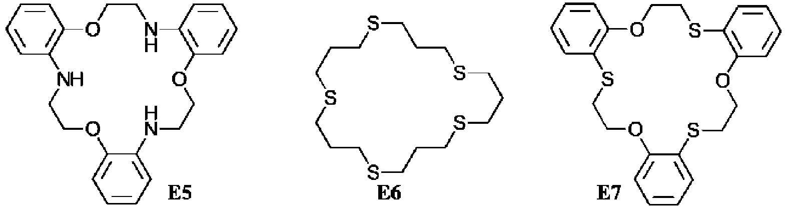

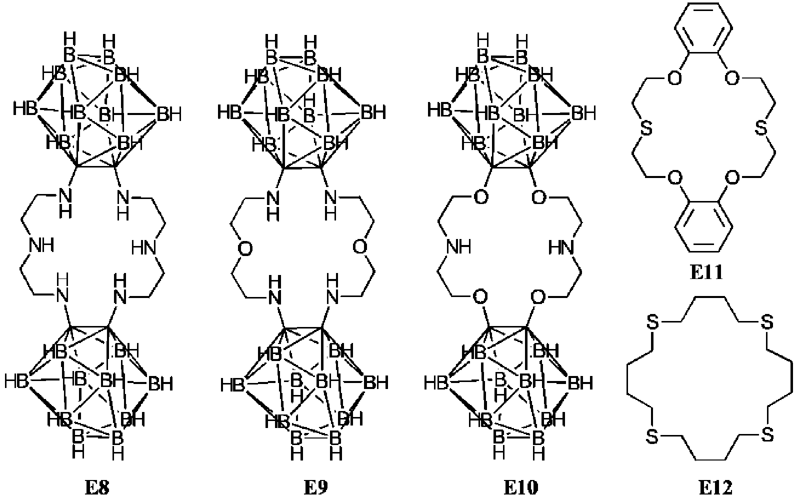

5. Composé de coordination organométallique selon l'une des revendications 1 à 4, dans lequel le composé de coordination est constitué d'un cation europium divalent et d'anions iodure et d'un ligand organique macrocyclique, l'europium, le ligand macrocyclique et les anions iodure étant en un rapport molaire de 1:1:2.

6. Couche comprenant
(a) au moins un composé de coordination organométallique, formé d'un cation europium divalent, d'un ligand organique macrocyclique et d'anions iodure en une quantité permettant de rendre le composé de coordination électriquement neutre, le ligand organique macrocyclique comprenant 16 à 23, de préférence 18 à 20 atomes de cycle dans un seul cycle macrocyclique accueillant l'europium divalent, dans laquelle le ligand organique macrocyclique répond à la formule (1-1) : 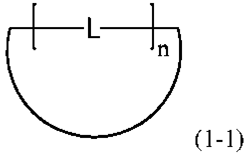
• n valant 4 à 6 ; plus préférablement 6 et
• L étant indépendamment à chaque occurrence un groupe organique divalent formé par élimination de deux atomes d'hydrogène d'une molécule organique contenant au moins deux atomes d'hydrogène,
∘ la séquence d'atomes la plus courte dans chaque L entre les deux liaisons de chaque L avec le reste du macrocycle dans le ligand macrocyclique étant de 2 à 4, de préférence 3 ou 4 atomes, et
∘ l'un de ces 2 à 4, de préférence 3 ou 4 atomes indépendamment pour chaque L étant choisi parmi les hétéroatomes B, N, P, S, Se, Si ou O, de préférence N, S, Se ou O, les autres atomes se trouvant dans la séquence d'atomes la plus courte étant le carbone,
dans laquelle de préférence les hétéroatomes se trouvant dans le macrocycle ne sont pas voisins et dans laquelle toutes les structures cycliques supplémentaires, faisant partie du ligand organique macrocyclique en plus du macrocycle lui-même, sont liées de façon covalente à un atome du macrocycle ou font partie du macrocycle par annélation 1,2-, 1,3- ou 1,4- de la structure cyclique supplémentaire au macrocycle et ne sont pas de plus liées de façon covalente à d'autres atomes du macrocycle,
et
(b) au moins un second composé organique électriquement neutre différent de celui-ci, dans laquelle l'au moins un composé de coordination organométallique (a) est incorporé dans l'au moins un second composé organique électriquement neutre (b),
la couche ayant de préférence une ou plusieurs des caractéristiques suivantes :
- le second composé (b) est un matériau hôte à charge neutre ;
- le second composé organique (b) a une énergie de l'état triplet supérieure à 2,5 eV,
de préférence supérieure à 2,6 eV et plus préférablement supérieure à 2,7 eV ;
- les composés (a) et (b) sont physiquement mélangés ou le second composé à charge neutre (b) a une masse moléculaire Mₙ supérieure à 1000 g/mol et le composé de coordination (a) et le second composé à charge neutre (b) sont chimiquement liés l'un à l'autre, par exemple par une liaison chimique covalente ou de coordination ;
- le composé de coordination (a) est incorporé dans l'au moins un second composé organique électriquement neutre (b) en une proportion de 0,1 à 99 % en volume, par rapport au mélange qui est de 100 % en volume ;
- le second composé organique (b) a une plus faible affinité pour les trous par comparaison avec celle du composé de coordination électriquement neutre (a) ;
- le second composé organique (b) a une plus faible affinité pour les électrons par comparaison avec celle du composé de coordination portant une seule charge positive (a) ;
- le second matériau est un matériau organique de transport de charges capable de transporter des charges positives ou négatives.

7. Couche selon la revendication 6, dans laquelle l'au moins un composé de coordination organométallique (a) est choisi parmi les composés de coordination organométalliques tels que définis dans l'une des revendications 1 à 5.

8. Dispositif électronique organique, comprenant :
une première électrode ;
une seconde électrode ; et
une couche organique disposée de telle sorte qu'elle est électriquement intercalée entre les première et seconde électrodes, dans lequel la couche organique comprend au moins un composé de coordination organométallique, formé d'un cation europium divalent, d'un ligand organique macrocyclique et d'anions iodure en une quantité permettant de rendre le composé de coordination électriquement neutre, le ligand organique macrocyclique comprenant 16 à 23, de préférence 18 à 20 atomes de cycle dans un seul cycle macrocyclique accueillant l'europium divalent, dans lequel le ligand organique macrocyclique répond à la formule (1-1) : 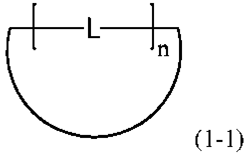
• n valant 4 à 6 ; plus préférablement 6 et
• L étant indépendamment à chaque occurrence un groupe organique divalent formé par élimination de deux atomes d'hydrogène d'une molécule organique contenant au moins deux atomes d'hydrogène,
∘ la séquence d'atomes la plus courte dans chaque L entre les deux liaisons de chaque L avec le reste du macrocycle dans le ligand macrocyclique étant de 2 à 4, de préférence 3 ou 4 atomes, et
∘ l'un de ces 2 à 4, de préférence 3 ou 4 atomes indépendamment pour chaque L étant choisi parmi les hétéroatomes B, N, P, S, Se, Si ou O, de préférence N, S, Se ou O, les autres atomes se trouvant dans la séquence d'atomes la plus courte étant le carbone,
dans lequel de préférence les hétéroatomes se trouvant dans le macrocycle ne sont pas voisins et dans lequel toutes les structures cycliques supplémentaires, faisant partie du ligand organique macrocyclique en plus du macrocycle lui-même, sont liées de façon covalente à un atome du macrocycle ou font partie du macrocycle par annélation 1,2-, 1,3- ou 1,4- de la structure cyclique supplémentaire au macrocycle et ne sont pas de plus liées de façon covalente à d'autres atomes du macrocycle,
ou la couche organique est telle que définie dans la revendication 6 ou 7, de préférence dans lequel le dispositif électronique organique est un dispositif optoélectronique, le dispositif optoélectronique étant de préférence au moins l'un d'une diode électroluminescente organique, d'un photodétecteur organique ou d'une cellule photovoltaïque.

9. Dispositif électronique organique selon la revendication 8, dans lequel l'au moins un composé de coordination organométallique (a) est choisi parmi les composés de coordination organométalliques tels que définis dans l'une des revendications 1 à 5.

10. Procédé de formation d'une couche selon la revendication 6 ou 7 ou d'un dispositif électronique organique selon la revendication 8 ou 9, le procédé comprenant :
la formation d'une couche du composé de coordination organométallique (a) telle que définie dans la revendication 6 ou 7 ou la formation de la couche telle que définie dans la revendication 8 ou 9,
dans lequel la couche est déposée à partir d'une phase gazeuse, en particulier à l'aide d'un processus d'évaporation et/ou de sublimation et/ou avec gaz vecteur ou dans lequel la couche est déposée à partir d'une solution, la solution étant alors de préférence constituée essentiellement de solvants organiques présentant un indice de polarité inférieur à 5,0, de préférence inférieur à 4,0, plus préférablement inférieur à 3,0.

11. Utilisation d'un composé de coordination organométallique selon l'une quelconque des revendications 1 à 5 ou d'une couche selon la revendication 6 ou 7 en tant que matériau électroluminescent passif ou actif dans des applications électroniques électroluminescentes ou en tant que colorant ou agent améliorant le contraste pour la tomographie par résonance magnétique.
